# EUROPÄISCHE PATENTSCHRIFT

(11) **EP 1 791 257 B1**
(45) Veröffentlichungstag und Bekanntmachung des Hinweises auf die Patenterteilung: **24.12.2014**
(21) Anmeldenummer: 06022264.3
(22) Anmeldetag: 25.10.2006
(51) Int. Cl.: H03K 5/08, H03K 5/003, H03M 1/06, H03M 1/12, H04B 10/69, H04L 25/06

(54) **Verfahren und Vorrichtung zur Datenübertragung mit analogen Signalen**
Method and apparatus for data transmission using analog signals
Procédé et appareil pour la transmission de données avec des signaux analogiques

(30) Priorität: 29.11.2005 DE 102005057240
(43) Veröffentlichungstag der Anmeldung: 30.05.2007
(60) Teilanmeldung: 10011958.5
(73) Patentinhaber: Prof. Dr. Horst Ziegler und Partner GbR, 70499 Stuttgart (DE)
(72) Erfinder: Ziegler, Horst, 33100 Paderborn (DE); Steffens, Andreas, 33102 Paderborn (DE)
(74) Vertreter: Ostertag, Reinhard

(56) Entgegenhaltungen:
- US-A1- 2003 080 784
- US-B1- 6 240 283

## Beschreibung

Die Erfindung betrifft ein Verfahren zur Datenübertragung nach dem Oberbegriff des Patantanspruchs 1.

Unter ZUSTANDS-Zeit soll hier und in den Ansprüchen eine Zeit verstanden werden, in welcher ein Signal einen vorgegebenen Zustand aufweist, der z.B. "EIN" oder "AUS" bzw. "1" oder "0" sein kann

Außerdem betrifft die Erfindung eine Vorrichtung zur Datenübertragung nach dem Oberbegriff des Patentanspruchs 21.

Unter einem analogen Signal soll in der vorliegenden Beschreibung und den Ansprüchen ein Signal verstanden werden, dessen Amplitude kontinuierlich veränderlich ist, unter einem digitalen oder binären Signal ein solches, dessen Amplitude nur einen von zwei vorgegebenen Werten "0" und "1" annehmen kann.

Insbesondere bekannte Verbrauchsmessgeräte (Heizkosten-Verteiler, Wasser-, Wärme- Gas- und Stromzähler), und auch viele andersartige mobile oder ortsfeste elektronische Geräte mit Netz- oder Batteriebetrieb, weisen zur Kommunikation mit anderen, insbesondere auch mobilen Geräten, Vorrichtungen zur Datenübertragung auf. Mit diesen Vorrichtungen werden mit wenigstens einem analogen optoelektronischen Signal, insbesondere mit einem sichtbaren oder infraroten Lichtsignal in Form von Lichtimpulsen, Daten übertragen. Entsprechende Sender weisen hierzu vorzugsweise Halbleiter-LED's (Light Emitting Diodes) zur Erzeugung der Lichtsignale auf. Entsprechende Empfänger umfassen optoelektronische Empfängerbauelementen, insbesondere Fotodioden, Fototransistoren, Fotowiderstände oder Fotozellen. Mit den optoelektronischen Empfängerbauelementen werden die vom Sender erzeugten Lichtsignale erfasst und in entsprechende analoge optoelektronische Spannungs- oder Strom- oder Widerstandssignale umgesetzt. Diese analogen Signale können dann verstärkt und/oder gefiltert und bei derzeit marktüblichen digitalen Datenübertragungsvorrichtungen durch einen Schwellwertvergleich vorzugsweise unter Verwendung eines Analog-Komparators in binäre elektrische Datensignale, zur Weiterverarbeitung vorzugsweise durch einen Mikroprozessor, umgewandelt werden.

Die analogen Signale können durch Fremdsignale, hervorgerufen beispielsweise durch Tageslicht, technisches Fremdlicht, Fertigungs-Offsetsignale oder thermische oder zeitliche Driftsignale des optoelektronischen Empfängerbauteils oder gegebenenfalls des Verstärkers/Filters, überlagert werden. Zur Elimination solcher Fremdsignale werden bei der digitalen Datenübertragung zur optischen Kodierung von Datenbits meist Lichtimpulse anstelle von statischen Lichtpegeln eingesetzt. Dies hat den Vorteil, dass der mittlere Strombedarf des Senders, insbesondere eines Leuchtmittels des Senders, minimiert wird. Beispielsweise wird eine zu übertragende "0" als Lichtimpuls, eine zu übertragende "1" dagegen als das Fehlen eines Lichtimpulses kodiert. Die Datenübertragung erfolgt dabei meist mit einer festen Übertragungs- oder Taktrate (Baudrate).

Insbesondere bei mobilen Datensystemen, beispielsweise bei Mobiltelefonen (Handys), personal digital assistents (PDAs) oder Notebooks, in Verbindung mit einem zu dem mobilen Datensystem häufig stationären Gegenstück, wie beispielsweise einem Personal Computer (PC), werden derzeit binäre Daten mit Infrarot-Lichtimpulsen nach dem bekannten quasigenormten IrDA (Infrared Data Association)-Protokoll kodiert und organisiert. Gemäß diesem Protokoll werden die Daten in Form von verhältnismäßig kurz andauernden Lichtimpulsen übertragen.

Alternativ kann die Übertragung von binären optischen Daten nach dem bekannten ZVEI-Protokoll nach IEC 1107 organisiert sein. Dabei werden die Datenbits als impulsförmige Lichtpegel übertragen, deren Länge größer ist, als die Dauer der Lichtimpulse beim IrDA-Protokoll.

Empfangseinrichtungen bekannter Datenübertragungsvorrichtungen weisen oft Empfängerschaltungen auf, mit denen die analogen optoelektronischen Signale der häufig bereits in die Empfängerschaltungen integrierten optoelektronischen Empfängerbauelemente verstärkt, gefiltert und mit vorgegebenen Schwellwerten verglichen werden. Ein hierbei erzeugtes digitales Ausgangssignal kann einfach digital weiterverarbeitet werden. Zum Filtern werden insbesondere Hochpassfilter eingesetzt, mit denen langsam veränderliche Störeinflüsse abgetrennt werden. Häufig ist auch der Sender, beispielsweise eine integrierte Infrarot-LED, der einen eingebauten Impulsformer aufweisen kann, wobei die Empfängerschaltung in einen optoelektronischen Transceiverbaustein integriert ist. Im Sender kann dann bekanntermaßen auch eine schaltbare Konstantstromquelle integriert sein. Durch paarweise Anordnung von solchen optoelektronischen Transceiverbausteinen ist derzeit eine komplette bidirektionale Übertragungsstrecke mit einer Reichweite, also einem Kommunikationsabstand zwischen den miteinander kommunizierenden Geräten beziehungsweise Datensystemen, im Bereich von bis 2 m realisierbar.

Damit dieser Kommunikationsabstand mit Transceiverbausteinen oder mit separaten Sende- und Empfangseinrichtungen erreichbar ist, muss der Schwellwertvergleich im Empfänger abhängig von der Signalstärke des empfangenen Lichtimpulses entsprechend empfindlich sein. Gleichzeitig muss jedoch verhindert werden, dass ein Störsignal, insbesondere ein Offset eines Vergleicher-Mittels der Empfangseinrichtung, insbesondere eines Komparators, fälschlicherweise als dem Datensignal zugehörig erfasst wird.

Auf dem Markt erhältliche Vergleicher-Mittel für bekannte Empfangseinrichtungen, insbesondere in Transceiverbausteine enthaltene Empfangseinrichtungen, mit kleinen maximalen Offsets sind aufwändig herzustellen und auch teuer. Darüber hinaus lässt der Strombedarf bekannter Empfangseinrichtungen eine dauernde Empfangsbereitschaft batteriebetriebener Geräte mit langer Batterielebensdauer, wie beispielsweise bei Verbrauchsmessgeräten mit Batterielebensdauern von 5 - 15 Jahren, nicht zu.

Ein Verfahren sowie eine Vorrichtung der eingangs genannten Art ist aus der US 2003/0 080 784 A1 bekannt geworden. Dort ist vorgesehen, dass eine wake-up-Schaltung dann ansprechen soll, wenn ein von außen empfangenes Radiosignal einen bestimmten Schwellwert übersteigt. Hierzu wird ein Komparator benötigt, welcher eine ggf. auch negative Offset-Spannung aufweisen kann. Falls eine solche negative Offset-Spannung betragsmäßig größer wäre als der Schwellwert, könnte das wake-up-Signal nicht erzeugt werden. Um dieses Problem zu lösen, wird während eines Justiervorgangs im Werk die Polarität der Offset-Spannung invertiert; die Justierdaten werden in einem nichtflüchtigen Speicher abgelegt. Das Problem einer möglichen zeitlichen Drift der Offset-Spannung während der Betriebsdauer wird dadurch allerdings nicht gelöst.

Aufgabe der vorliegenden Erfindung ist, ein Verfahren und eine Vorrichtung der eingangs genannten Art so zu gestalten, dass technisch einfach auch mit insbesondere preiswerten Mitteln, insbesondere Vergleicher-Mitteln, die einen großen maximalen Offset aufweisen können, eine Vergrößerung der typischen Lichtempfindlichkeit der Empfangseinrichtung und damit eine Vergrößerung des Kommunikationsabstandes erreicht werden kann, wobei stets sicher gestellt sein soll, dass auch bei Vorliegen eines Störsignals, insbesondere eines Offsets nahe dem maximalen Offset des Vergleicher-Mittels, nie das Störsignal eine fälschliche Erfassung eines Datensignals bewirkt.

Diese Aufgabe wird erfindungsgemäß dadurch gelöst, dass das analoge Signal mit einem vorgegebenen analogen Schwellwert verglichen wird und ein binäres Ausgangssignal solange erzeugt wird, solange der Vergleich ergibt, dass eine Amplitude des analogen Signals größer als der Schwellwert ist, wobei das analoge Signal und das Schwellwertsignal vertauscht werden, wenn das binäre Ausgangssignal länger erzeugt wird als eine vorgegebene maximale Dauer-ZUSTANDS-Zeit für das binäre Ausgangssignal.

Erfindungsgemäß wird also die Überschreitung der maximalen Dauer-ZUSTANDS-Zeit für das binäre Ausgangssignal als Indiz für das Vorliegen einer fälschlichen Erfassung eines Datensignals, insbesondere eines Dauersignals am Ausgang des Vergleicher-Mittels betrachtet, welches insbesondere durch einen positiven Offset des Vergleicher-Mittels hervorgerufen sein kann, der schon alleine oder gemeinsam mit etwaigen Störsignalen größer als der Schwellwert ist.

Das analoge Signal unterscheidet sich nämlich von dem Offset und/oder dem Störsignal dadurch, dass das analoge Signal eine begrenzte Dauer-ZUSTANDS-Zeit hat. Das heißt, das analoge Signal ist zwangsläufig stets nach den sich aus der Übertragungsrate und dem Übertragungsprotokoll ergebenden Maximalzeiten logisch "AUS". Dem gegenüber können der Offset und/oder das Störsignal länger als die Dauer-ZUSTANDS-Zeit anliegen. Wenn also der Vergleich ein Ausgangssignal liefert, das länger andauert als die maximale Dauer-ZUSTANDS-Zeit, bedeutet dies, dass es nicht von dem analogen optoelektronischen Signal, sondern fehlerbedingt ist, insbesondere von zu starkem Offset herrührt.

Um der fälschlichen Datensignalerfassung entgegenzuwirken, wird eine analogelektrische Umpolung der Polarität des analogelektrischen Signals vorgenommen. Aus dem positiven Offset wird so ein negativer Offset, der dann kleiner ist als der Schwellwert. Das daueraktive Ausgangssignal verschwindet in Folge, und im Weiteren ist trotz des großen Offsets eine Datenerfassung mit großer Empfindlichkeit möglich, ohne dass es zu einer Dauerblockade der optischen Kommunikation kommt.

Es reicht also ein verhältnismäßig kleiner externer Schwellwert aus, um das Signal von einer Störung zu unterscheiden, so dass beispielsweise lediglich eine kleine Spannungsquelle zur Bereitstellung einer Schwellenspannung erforderlich ist. Damit ergibt sich bei dem am häufigsten vorkommenden Offset insbesondere von marktüblichen als Vergleicher-Mittel verwendeten Komparatoren nahe 0 mV eine sehr gute Empfindlichkeit.

Bei negativen Offsets verringert sich zwar die Empfindlichkeit durch den sich daraus ergebenden größeren relativen Schwellwert etwas, aber eine solche eher selten vorkommende geringere Empfindlichkeit und ein damit reduzierter Kommunikationsabstand eines gerade noch in der Spezifikation liegenden Ausreißerexemplars eines Vergleicher-Mittels ist insbesondere für die Anwendung bei einer mobilen optischen Datenablesung von Verbrauchszählern akzeptabel.

Auf diese Weise können auch mit technisch einfachen insbesondere preiswerten Vergleicher-Mitteln, die insbesondere große maximale Offsets aufweisen, kleine Schwellwerte, also große typische Lichtempfindlichkeiten der Empfangseinrichtung, und damit große Kommunikationsabstände erreicht werden, ohne dass Störsignale fälschlicherweise als Datensignale erfasst werden.

Die Erzeugung von analogen Datensignalen mit begrenzter Dauer-ZUSTANDS-Zeit erfordert darüber hinaus auf der Senderseite einen deutlich geringeren Energieaufwand als die Erzeugung von Dauersignalen, so dass beispielsweise bei batteriebetriebenen Geräten längere Standzeiten erzielbar sind.

Des Weiteren ist das Verfahren zur Elimination eines Offsets eines Vergleicher-Mittels auch bei Datenkodierungen mit stark dateninhaltsabhängigem Mittelwert, wie dies beispielsweise beim ZVEI-Protokoll der Fall ist, möglich.

Technisch einfach kann das analoge Signal mit einem analogelektrischen Komparator mit dem analogen Schwellwert verglichen werden und die Vertauschung von analogem optoelektronischen Signals und Referenzsignal kann mit einer steuerbaren Signalvertauschungseinrichtung erfolgen.

Zweckmäßigerweise kann die Datenübertragung mit Bit- und/oder Byte-orientierten Protokollen organisiert werden. Byte-orientierte Protokolle haben den Vorteil, dass mit ihnen Standardcodes, beispielsweise ASCII (American Standard Code for Information Interchange)-Codes, einfach übertragen werden können. Insbesondere bei bekannten Microcomputern und PCs sind solche Standardcodes weit verbreitet, so dass es einfach ist, beispielsweise reine ASCII-Texte zwischen verschiedenen Programmen oder Plattformen, also Betriebssystemen, auszutauschen.

Bit-orientierte Protokolle haben den Vorteil, dass die Übertragung nicht von einer Zeichenkodierung abhängig und nicht an Bytegrenzen gebunden ist. Des Weiteren sind für die Übertragung keine reservierten Zeichen erforderlich, da die Datenübertragung durch definierte Bitfolgen gesteuert wird.

Ferner können die begrenzte Dauer-ZUSTANDS-Zeit und die maximale Dauer-ZUSTANDS-Zeit von dem Bit- und/oder Byte-orientierten Protokoll vorgegeben werden, so dass keine separate Vorgabe der der maximalen Dauer-ZUSTANDS-Zeit erforderlich ist. Diese Zeiten können entsprechend dem verwendeten Protokoll standardisiert werden.

Ist der Offset zwar positiv aber kleiner als der Schwellwert, so erhöht sich zunächst nur die Empfindlichkeit. Kommt der positive Offset dagegen in die Nähe des Schwellwerts, so wird die Schaltung zwar noch nicht daueraktiv aber schon sehr empfindlich gegen optische und elektrische Störungen. Führen solche oder andere Störungen zu Bitfehlern, so kann dies spätestens auf einer Sicherungsschicht des Übertragungsprotokolls als Bitfehler oder als Timing-Fehler erkannt werden. In diesem Fall kann dann versuchsweise die Polarität des analogen optoelektronischen Signals ebenfalls in den jeweils anderen Zustand geändert und die Kommunikation wiederholt werden.

Zu diesem Zweck kann bei einer weiteren vorteilhaften Ausgestaltung des Verfahrens eine Überschreitung der maximalen Dauer-ZUSTANDS-Zeit mit einem retriggerbaren Monoflop und einem nachgeschalteten Flipflop erkannt werden. Dies hat den Vorteil, dass der einmal erreichte Umschaltzustand in dem Flipflop gespeichert werden kann. Die nächste Kommunikation wird mit dem einmal gelernten Umpolzustand gestartet, da sich das Vorzeichen des Offsets, wenn überhaupt, später nur sehr langsam ändert. Dadurch wird es meist nur einmal, auf jeden Fall aber sehr selten, zu einem solchen Fehlversuch mit nachfolgender Wiederholung mit invertierter Empfangspolarität des Vergleicher-Mittels kommen.

Alternativ kann aus dem gleichen Grund die Überschreitung der maximalen Dauer-ZUSTANDS-Zeit und die Änderung der Polarität des analogen Signals insbesondere durch eine Digitalschaltung oder eine Software eines Mikrocontrollers oder Mikroprozessors, insbesondere eines dem Komparator nachgeschalteten oder mit dem Komparator und/oder der analogelektrischen Signalvertauschungseinrichtung integrierten Zeitüberwachungskreises oder eines Mikrocontrollers oder Mikroprozessors, realisiert werden. Bei Verwendung eines Mikrocontrollers oder Mikroprozessors kann darüber hinaus die Software individuell geändert und angepasst werden. Außerdem kann sie in einen ohnehin vorhandenen Mikrocontroller integriert werden, so dass kein separates Bauteil, beispielsweise ein Flipflop, erforderlich ist.

Zur Änderung der Polarität des analogen Signals kann das binäre Ausgangssignal insbesondere mit der Digitalschaltung oder der Software des Mikrocontrollers oder Mikroprozessors invertiert werden und mit dem invertierten Ausgangssignal die Änderung der Polarität des analogen Signals realisiert werden, indem die analogelektrische Signalvertauschungseinrichtung entsprechend angesteuert wird.

Die geänderte Polarität des analogen Signals kann bis zu einer weiteren Überschreitung der maximalen Dauer-ZUSTANDS-Zeit oder bis zur Erkennung eines Fehlers bei der Datenübertragung, insbesondere eines Fehlers im Bitbeziehungsweise Byte-orientierten Protokoll, oder bis zur Erkennung eines Timingfehlers oder bis zu einer Kommunikationspause beibehalten werden. Auf diese Weise wird die Umpolung zeitsparend nur einmal vorgenommen, wenn die Überschreitung der maximalen Dauer-ZUSTANDS-Zeit lediglich von einem großen Offset des Vergleicher-Mittels, insbesondere des Komparators, herrührt, da dieser Offset in der Regel dauerhaft ist.

Ferner kann die Änderung der Polarität des analogen Signals mit einem entsprechenden Wechsel eines Logikpegels des digitalen Signals gekoppelt werden.

Bei einer besonders einfachen Ausgestaltung des Verfahrens, mit der ein besonders großer Kommunikationsabstand zwischen dem Sender und dem Empfänger ermöglicht wird, kann für den analogen Schwellwert ein Wert vorgegeben werden, der kleiner ist als ein maximaler Offset insbesondere eines Vergleicher-Bauteils, mit dem das analoge Signal mit dem Schwellwert verglichen wird.

Um den Einfluß von Störsignalen zu verringern und einen deutlich größeren Kommunikationsabstand zu ermöglichen, können gegebenenfalls enthaltene konstante oder langsam veränderliche Störanteile aus dem analogen Signal insbesondere mit einem geeigneten analogelektrischen Filter, insbesondere einem Hochpassfilter, vorzugsweise einem CR-Glied, zumindest weitgehend eliminiert werden, bevor das analoge Signal mit dem analogen Schwellwert verglichen wird beziehungsweise bevor seine Polarität geändert wird.

Alternativ kann zur Verringerung des Einflusses von Störsignalen das analoge Signal mit der Summe des Schwellwertes und dem geglätteten analogen Signal verglichen werden, insbesondere eine analoge Signalspannung auf einen der beiden Eingänge der Signalvertauschungseinrichtung mit dem nachgeschalteten Komparator und auf den anderen Eingang der Signalvertauschungseinrichtung die durch einen Tiefpass, insbesondere ein RC-Glied, geglättete analoge Signalspannung zuzüglich einer analogen Schwellenspannung gegeben werden.

Bei einer anderen alternativen Ausgestaltung des Verfahrens, bei dem ein Empfängerbauteil, insbesondere eine Fotodiode, ein Fototransistor, ein Fotowiderstand oder eine Fotozelle, im Generatormodus betrieben wird, kann zur Verringerung des Einflusses von Störsignalen der Schwellwert als geglätteter Bruchteil der Amplitude des analogen Signals bestimmt werden und mit dem nicht geglätteten analogen Signal verglichen werden, insbesondere ein Spannungsbruchteil der analogen Signalspannung auf einen der beiden Eingänge der Signalvertauschungseinrichtung mit dem nachgeschalteten Komparator und auf den anderen Eingang der Signalvertauschungseinrichtung die insbesondere mit einem Tiefpass geglättete analoge Signalspannung gegeben werden.

Um den Energieverbrauch deutlich zu verringern und so die Standzeiten von batteriebetriebenen Geräten deutlich zu verlängern, können die Daten, insbesondere die Datenbits, der optischen Datenübertragung durch Lichtimpulse mit einer mittleren Hellzeit von weniger als 25% einer Bitzeit kodiert werden.

Bei einer weiteren vorteilhaften Ausgestaltung des Verfahrens können die Daten, insbesondere die Datenbits, entsprechend der Quasinorm mit der Bezeichnung "IrDA" impulskodiert werden. Auf diese Weise können zur Datenübertragung weit verbreitete, dieser Quasinorm entsprechende, Infrarot-Schnittstellen verwendet werden.

Alternativ können die Daten, insbesondere Datenbytes, entsprechend der ZVEI-Norm (IEC 1107) kodiert werden, um einen Einsatz in Verbindung mit Schnittstellen, die dieser Norm entsprechen, zu ermöglichen.

Die Daten können zwischen mindestens einem mobilen Gerät und einem ortsfesten oder zwischen zwei mobilen Geräten übertragen werden. Aufgrund des großen Kommunikationsabstandes, der mit der erfindungsgemäßen Datenübertragung erreicht werden kann, kann der Abstand zwischen den mobilen Geräten innerhalb großer Grenzen frei variiert werden.

Bei einer besonders vorteilhaften Ausgestaltung des Verfahrens können die Daten von und/oder zu einem insbesondere ortsfesten Verbrauchszähler, insbesondere einem Heizkosten-Verteiler oder einem Strom-, Gas-, Wasser- oder Wärmemengenzähler, übertragen werden. Auf Grund des geringen Energiebedarfs des erfindungsgemäßen Datenübertragungsverfahrens kann dann sowohl der ortsfeste Verbrauchszähler, bei dem lange Standzeiten gefordert sind, als auch insbesondere ein mobiles Gegengerät batteriebetrieben werden.

Die erfindungsgemäße Vorrichtung zeichnet sich dadurch aus, dass der Umwandler ein Vergleicher-Mittel zum Vergleichen des analogen Signals mit einem vorgegebenen analogen Schwellwert und zur Erzeugung eines binären Ausgangssignals wenn eine Amplitude des analogen Signals größer als der analoge Schwellwert ist, und eine steuerbare analogelektrische Signalvertauschungseinrichtung, mit der die Polarität des analogen Signals beim Erreichen einer vorgegebenen maximalen Dauer-ZUSTANDS-Zeit für das binäre Ausgangssignal änderbar ist, aufweist.

Auf diese Weise sind auch einfache und insbesondere preiswerte Vergleicher-Mittel einsetzbar, die einen großen maximalen Offset aufweisen können.

Darüber hinaus ist eine große Lichtempfindlichkeit realisierbar, so dass auch bei einem großen Kommunikationsabstand zwischen dem Sender und dem Empfänger eine zuverlässige Datenübertragung möglich ist.

Bei einer vorteilhaften und technisch einfachen Ausführungsform kann das Vergleicher-Mittel ein analogelektrischer Komparator sein und wenigstens ein Ausgang der Signalvertauschungseinrichtung wenigstens einem Eingang des Komparators vorgeschaltet sein.

Um die Vorrichtung bei Geräten einsetzen zu können, die Übertragungsprotokolle nach weit verbreiteten Standards einsetzen, insbesondere bei bekannten Minicomputern und PCs, kann die Datenübertragung mit Bit- und/oder Byte-orientierten Protokollen organisiert sein.

Um die vorgegebenen Daten entsprechend dem verwendeten Protokoll standardisieren zu können, können die begrenzte Dauer-ZUSTANDS-Zeit und die maximale Dauer-ZUSTANDS-Zeit von dem Bit- und/oder Byte-orientierten Protokoll vorgegeben sein.

Bei einer weiteren besonders vorteilhaften Ausführungsform kann dem Umwandler, insbesondere dem Vergleicher-Mittel, ein retriggerbares Monoflop und ein Flipflop zur Erfassung einer Überschreitung der maximalen Dauer-ZUSTANDS-Zeit nachgeschaltet sein. Mit dem retriggerbaren Monoflop ist einfach die maximale Dauer-ZUSTANDS-Zeit vorgebbar und in dem Flipflop kann der einmal erreichte Umschaltzustand einfach gespeichert werden.

Alternativ kann bei einer weiteren besonders vorteilhaften Ausführungsform eine Digitalschaltung oder ein Mikrocontroller oder Mikroprozessor mit einer Software zur Erfassung der Überschreitung der maximalen Dauer-ZUSTANDS-Zeit und zur Änderung der Polarität des analogen optoelektronischen Signals, insbesondere eine dem Vergleicher-Mittel nachgeschaltete oder mit dem Vergleicher-Mittel und/oder der analogelektrischen Signalvertauschungseinrichtung integrierte Digitalschaltung oder ein Mikrocontroller oder Mikroprozessor, vorgesehen sein. Die Software ist besonders einfach an das jeweilige Gerät, welches die Vorrichtung zur Datenübertragung aufweist, und/oder unterschiedliche Empfängerbauelement, insbesondere Fotoelemente, anpassbar. Darüber hinaus kann ein ohnehin in dem Gerät vorhandener Mikrocontroller oder Mikroprozessor lediglich durch entsprechende Programmierung verwendet werden, so dass keine zusätzlichen Bauteile erforderlich sind.

Zweckmäßigerweise kann die Digitalschaltung beziehungsweise die Software des Mikrocontrollers oder Mikroprozessors ein Mittel zum Invertieren des digitalen Ausgangssignals aufweisen und die analogelektrische Signalvertauschungseinrichtung mit der Digitalschaltung beziehungsweise dem Mikrocontroller oder Mikroprozessor zum Vertauschen von analogem Meßsignal und Referenzsignal steuerbar verbunden sein. Auf diese Weise ist technisch einfach mit wenigen Bauteilen eine Signalvertauschung realisierbar.

Um eine einmal auf den Offset des verwendeten Vergleicher-Mittels eingestellte Polarität beibehalten zu können, kann vorteilhafterweise ein Speichermittel, insbesondere ein Mikrocontroller oder Mikroprozessor mit einer Software oder ein Flipflop, zum Halten der geänderten Polarität des analogen Signals bis zu einer weiteren Überschreitung der maximalen Dauer-ZUSTANDS-Zeit oder bis zur Erkennung eines Fehlers bei der Datenübertragung, insbesondere eines Fehlers im Bit- und/oder Byte-orientierten Protokoll, oder bis zur Erkennung eines Timingfehlers oder bis zu einer Kommunikationspause, vorgesehen sein.

Zweckmäßigerweise kann die Vertauschung von analogem Meßsignal und Referenzsignal mit einem entsprechenden Wechsel des Logikpegels des digitalen Signals am Ausgang des Vergleicher-Mittels gekoppelt sein.

Der analoge Schwellwert kann kleiner sein als ein maximaler Offset des Vergleicher-Mittels, insbesondere des Komparators, insbesondere kann das analoge Signal an einem ersten Eingang des Vergleicher-Mittels und der analoge Schwellwert an einem zweiten Eingang des Vergleicher-Mittels anliegen. Auf diese Weise ist auch bei Offsets, die kleiner als der maximale Offset des Vergleicher-Mittels sind, mit der Signalumpolung ein durch den Offset hervorgerufener verfälschter Vergleich als solcher erkennbar.

Zur Realisierung einer hohen Empfindlichkeit des Empfängers und damit zur Vergrößerung des Kommunikationsabstandes kann dem Vergleicher-Mittel und/oder der analogelektrischen Signalvertauschungseinrichtung ein geeignetes analogelektrisches Filter, insbesondere ein Hochpassfilter, vorzugsweise ein RC-Glied, zum zumindest weitgehenden Eliminieren gegebenenfalls enthaltener konstanter oder langsam veränderlicher Störanteile aus dem analogen optoelektronischen Signal, vorgeschaltet sein.

Alternativ können zur Vergrößerung der Empfindlichkeit des Empfängers und damit zur Vergrößerung des Kommunikationsabstandes dem Vergleicher-Mittel und/oder der analogelektrische Signalvertauschungseinrichtung ein Mittel zur Glättung des analogen Signals, insbesondere ein Tiefpass, vorzugsweise ein RC-Glied, und ein Mittel zum Addieren des Schwellwertes und des am Ausgang des Tiefpasses anliegenden gemittelten analogen Signals vorgeschaltet sein, insbesondere kann das analoge Signal gleichzeitig an einem der beiden Eingänge der Signalvertauschungseinrichtung mit dem nachgeschalteten Vergleicher-Mittel und am Eingang des Tiefpasses anliegen, wobei der Tiefpass und ein Mittel zur Erzeugung einer den analogelektrischen Schwellwert charakterisierenden Schwellenspannung dem anderen Eingang der Signalvertauschungseinrichtung in Reihe vorgeschaltet sein können.

Bei einer weiteren alternativen Ausführungsform, bei der ein Empfängerbauteil, insbesondere eine Fotodiode, ein Fototransistor, ein Fotowiderstand oder eine Fotozelle, im Generatormodus betreibbar ist, kann zur Vergrößerung der Empfindlichkeit des Empfängers und damit zur Vergrößerung des Kommunikationsabstandes einem ersten Eingang des Vergleicher-Mittels und/oder der analogelektrischen Signalvertauschungseinrichtung ein Mittel zur Bildung eines Amplitudenbruchteils des analogen Signals, insbesondere ein Spannungsteiler, vorgeschaltet sein und einem zweiten Eingang des Vergleicher-Mittels und/oder der analogelektrischen Signalvertauschungseinrichtung ein Mittel zur Glättung des analogen Signals, insbesondere ein Tiefpass, vorgeschaltet sein.

Die Daten der Datenübertragung können kodierte Impulse mit einer mittleren EIN-Zeit von weniger als 25% einer Bitzeit sein, welche mit einem geringen Energieaufwand realisierbar sind. Dies ist insbesondere bei einer optischen Datenübertragung vorteilhaft.

Um die Vorrichtung bei weit verbreiteten Infrarot-Schnittstellen verwenden zu können, können die Daten, insbesondere die Datenbits, entsprechend der Quasinorm mit der Bezeichnung "IrDA" impulskodiert sind.

Alternativ können die Daten, insbesondere Datenbytes, entsprechend der ZVEI-Norm (IEC 1107) kodiert sein, so dass die Vorrichtung auch bei Schnittstellen, die diese Norm verwenden, einsetzbar ist.

Bei einer weiteren vorteilhaften Ausführungsform kann die Vorrichtung mit einem mobilen Gerät oder einem ortsfesten Gerät funktionell verbunden oder in dieses integriert sein. Insbesondere bei mobilen Geräten hat dies den großen Vorteil, dass wegen des großen Kommunikationsabstandes, welchen die Vorrichtung ermöglicht, das mobile Gerät flexibel auch in einem großen Abstand von dem Kommunikationsgegengerät platziert sein kann und dennoch eine problemlose und fehlerfreie Datenübertragung ermöglicht wird. Bei batteriebetriebenen Geräten, die mobil oder ortsfest sein können, ermöglicht der geringe Energiebedarf der Vorrichtung auch bei einer dauernden Empfangsbereitschaft lange Standzeiten der Geräte.

Bei einer weiteren besonders vorteilhaften Ausführungsform kann die Vorrichtung insbesondere mit einem ortsfesten Verbrauchszähler, insbesondere einem Heizkosten-Verteiler oder einem Strom-, Gas-, Wasser- oder Wärmemengenzähler, funktionell verbunden oder in diesen integriert sein. Gerade dort ist die durch den geringen Energiebedarf der Vorrichtung ermöglichte lange Standzeit der Geräte von enormem Vorteil, da diese Geräte bei einer dauernden Empfangsbereitschaft oft zwischen 5 und 15 Jahre möglichst wartungsfrei in Betrieb sein sollen.

Ausführungsbeispiele der Erfindung werden nachfolgend anhand der Zeichnung näher erläutert. In dieser zeigen:
- Figur 1: schematisch ein Schaltbild einer aus dem Stand der Technik bekannten Empfängerschaltung einer Vorrichtung zur Datenübertragung mit einer Fotodiode zum Empfangen eines optischen Datensignals;
- Figur 2: schematisch ein Amplituden-Zeit-Diagramm eines nach dem IrDA-Übertragungsprotokoll kodierten binären Datensignals;
- Figur 3: schematisch ein Amplituden-Zeit-Diagramm eines alternativen nach dem ZVEI-Übertragungsprotokoll kodierten binären Signals;
- Figur 4: schematisch ein Schaltbild eines dem in Figur 1 gezeigten ähnlichen Komparators zum Vergleichen einer analogen Signalspannung mit einer vorgegeben Schwellenspannung, wobei die Schwellenspannung größer als ein Offset des Komparators ist;
- Figur 5: schematisch einen Teil eines ersten Ausführungsbeispiels einer Empfängerschaltung einer erfindungsgemäßen Vorrichtung zur Datenübertragung;
- Figur 6: schematisch einen Teil eines zweiten Ausführungsbeispiels einer der in Figur 5 dargestellten ähnlichen Empfängerschaltung;
- Figur 7: schematisch einen Teil eines dritten Ausführungsbeispiels einer Empfängerschaltung;
- Figur 8: schematisch einen Teil eines vierten Ausführungsbeispiels einer Empfängerschaltung; und
- Figur 9: schematisch einen Teil eines fünften Ausführungsbeispiels einer Empfängerschaltung.

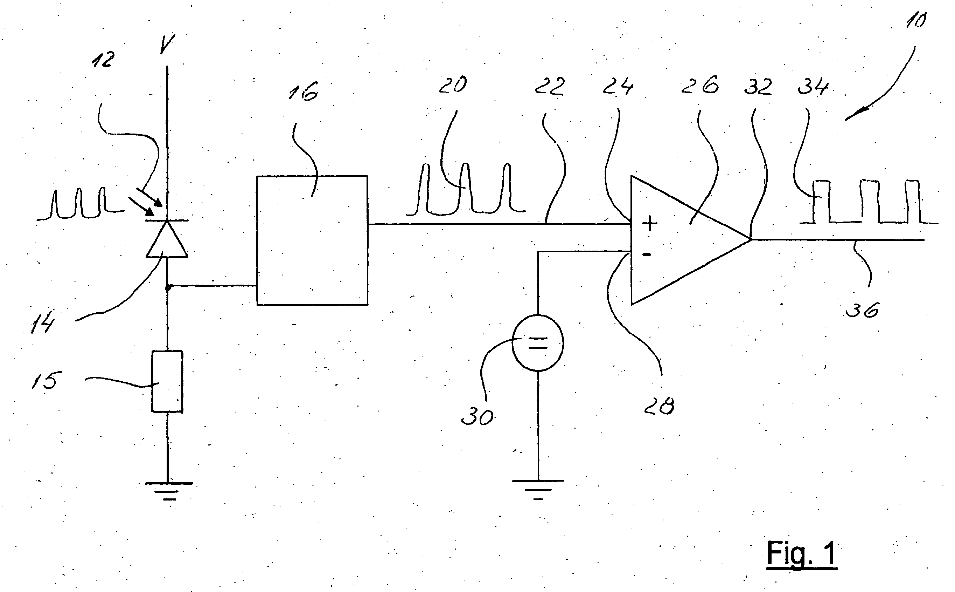

In Figur 1 ist eine insgesamt mit dem Bezugszeichen 10 bezeichnete aus dem Stand der Technik bekannte Empfängerschaltung einer Vorrichtung zur Datenübertragung dargestellt, die mit analogen optoelektronisch erhaltenen Signalen arbeitet.

Beim betrachteten Ausführungsbeispiel ist die ZUSTANDS-Zeit die EIN-Zeit des Signales, also die Zeit, in der das Signal den Pegel "1" hat.

Die Vorrichtung ist mit einem nicht dargestellten bekannten Verbrauchsmessgerät, beispielsweise einem Heizkosten-Verteiler, Wasser-, Wärme- Gas- und Stromzähler, verbunden. Sie dient zur Kommunikation mit einem anderen bekannten insbesondere auch mobilen, nicht dargestellten Gegengerät, von dem aus infrarote Lichtsignale 12 in Form von Lichtimpulsen, welche die zu übertragenden Daten charakterisieren, gesendet werden. Das Gegengerät weist hierzu einen entsprechenden Sender mit Halbleiter-LED's (Light Emitting Diode) zur Erzeugung der Lichtsignale auf.

Die Empfängerschaltung 10 weist in Figur 1 links eine Fotodiode 14 auf, mit der die infraroten Lichtsignale 12 in das analoge optoelektronische Signal umgesetzt werden. Die Fotodiode 14 ist mit ihrer einen Klemme auf Versorgungspotential V gelegt und mit ihrem anderen Anschluss über einen Widerstand 15 mit Masse verbunden. Der dazwischen liegende Knoten ist mit einem Eingang eines Filters /Ver-stärkers 16 verbunden, dem das analoge optoelektronische Signal zugeführt wird.

Anstelle der Fotodiode 14 kann die Empfängerschaltung 10 auch ein andersartiges optoelektronisches Empfängerbauelement, insbesondere einen Fototransistor, einen Fotowiderstand oder eine Fotozelle aufweisen, und das mit diesem erzeugte analoge optoelektronische Signal kann einem an das andersartige optoelektronische Empfängerbauelement angepassten und entsprechend geschalteten Filter/Verstärker 16 zugeführt werden. Es können auf diese Weise analoge optoelektronische Signale in Form von Spannungs-, Strom- oder Widerstandssignalen an den Filter/Verstärker 16 übermittelt werden.

Mit einem analogelektrischen Filter des Filters / Ver-stärkers 16 werden etwaige konstante oder zeitlich langsam veränderliche Störsignalanteile, die insbesondere von optischen oder elektrischen Störungen herrühren können, von dem analogen optoelektronischen Signal abgetrennt beziehungsweise das analoge optoelektronische Signal geglättet.

Außerdem wird das analoge optoelektronische Signal mit einem nicht dargestellten Verstärker verstärkt und an einem Ausgang des Filters/Verstärkers 16 als analoge Signalspannung 20 (photoelektrisches Nutzsignal) bereitgestellt.

Von dem Ausgang des Filters/Verstärkers 16 führt eine Signalleitung 22 zu einem ersten Eingang 24 eines analogen Komparators 26, der als Vergleicher-Mittel wirkt, an dem somit die analoge Signalspannung 20 anliegt.

Ein zweiter Eingang 28 des Komparators 26 ist mit einem Spannungsteiler einer Geräte-Versorgungsspannung des Verbrauchsmessgerätes verbunden, der einen Schwellwertgenerator 30 bildet. An dem Spannungsteiler wird eine vorgegebene Schwellenspannung abgegriffen und an den zweiten Eingang 28 des Komparators 26 angelegt.

Mit dem Komparator 26 wird die analoge Signalspannung 20 mit der Schwellenspannung verglichen. Ist die analoge Signalspannung 20 kleiner als die Schwellenspannung (dies ist der Fall wenn die Fotodiode 14 keinen Lichtimpuls empfängt) so wird an einem Ausgang 32 des Komparators 26 ein binäres Signal 34 in Form einer logischen "0" als binäres Aussignal bereitgestellt. Ist hingegen die analoge Signalspannung 20 größer als die Schwellenspannung so wird am Ausgang 32 des Komparators 26 eine logische "1" als binäres Ausgangssignal ausgegeben. Auf diese Weise wird mit dem Komparator 26 das analoge optoelektronische Signal in Form der analogen Signalspannung 20 in das binäre Signal 34 umgewandelt. Das binäre Signal 34 wird dann über eine Binär-Signalleitung 36 einem Mikroprozessor des Verbrauchsmessgerätes zugeführt, wo es digital weiterverarbeitet wird.

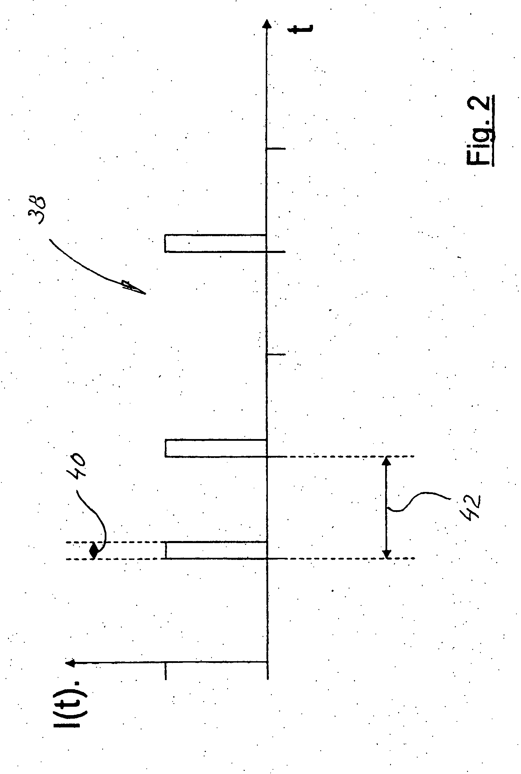

In Figur 2 ist ein Amplituden-Zeit-Diagramm eines nach dem quasigenormten IrDA-Übertragungsprotokoll kodierten binären Datensignals 38, welches mit der Empfängerschaltung 10 aus Figur 1 aus einer entsprechend kodierten impulsförmigen analogen Signalspannung umgewandelt werden kann, dargestellt. Die Amplitude des Datensignals 38 ist nach oben, der Zeitverlauf nach rechts aufgetragen. Eine zu übertragende "0" ist als Lichtimpuls, eine zu übertragende "1" dagegen als das Fehlen eines Lichtimpulses des ursprünglichen, aus dem in Figur 1 dargestellten ähnlichen Lichtsignal kodiert.

Unter der EIN-Zeit wird die Zeitdauer des transienten Zustandes verstanden.

Bei dem IrDA-Übertragungsprotokoll werden die Daten bei einer vereinbarten Übertragungsrate (Baudrate) übertragen, welche vorzugsweise mindestens 9600 Baud beträgt. Die Übertragungsrate kann statt dessen nach einer einer Verbindungsaufnahme folgenden protokolltechnischen Vereinbarung der kommunizierenden Geräte auch Zweierpotenzen von 9600 Baud betragen.

Bei dem in Figur 2 dargestellten Datensignal 38 beträgt die Dauer 40 der Lichtimpulse maximal 3/16 einer Periode (Bitzeit) 42, mindestens aber 1,84 µs. Die Bitzeit 42 ist mindestens gleich der Zeit, welche für den Empfang und die Speicherung eines Bits benötigt wird.

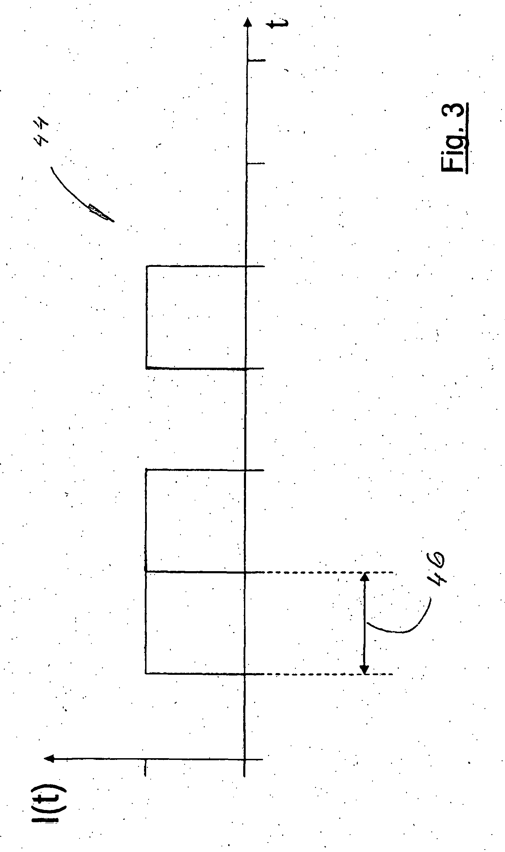

In Figur 3 ist schematisch ein in der Zuweisung der Achsen dem in Figur 2 dargestellten entsprechendes Amplituden-Zeit-Diagramm eines alternativ nach dem ZVEI-Übertragungsprotokoll nach IEC 1107 kodierten binären Datensignals 44, welches mit der Empfängerschaltung 10 aus Figur 1 aus einer entsprechend kodierten impulsförmigen analogen Signalspannung umgewandelt werden kann, dargestellt. Dabei werden die Datenbits als Pegel, deren Dauer einer Periode (Bitzeit) 46 entspricht, übertragen, wobei "0" dem Zustand "Licht an" und "1" dem Zustand "Licht aus" entspricht. Hierbei wird ein einfaches asynchrones Protokoll eines universellen asynchronen Empfangs- und Sendebausteins (UART-Protokoll) als Byte-orientiertes Protokoll eingesetzt, bei dem fünf bis acht Datenbits (Nutzbits) eines Bytes von einem Startbit, welches stets gleich "0" ist, und einem Stoppbit, welches stets gleich "1" ist, eingerahmt sind. Auch hier kommt im zeitlichen Abstand von maximal elf Bitzeiten 46 durch das Stoppbit mindestens ein "1"-Signal, welches dem Zustand "Licht aus" entspricht, vor.

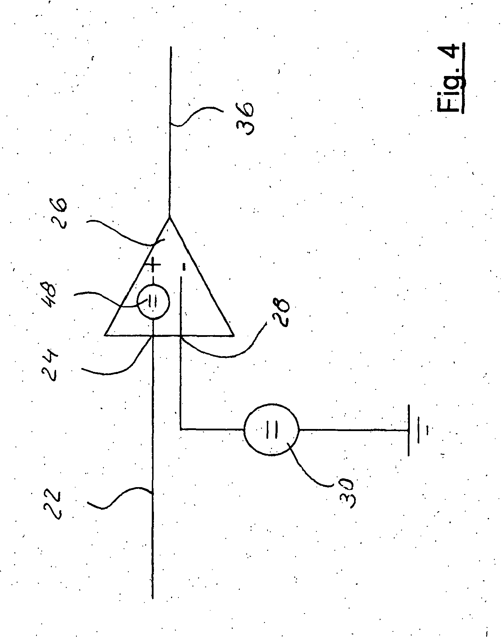

In Figur 4 ist schematisch ein Teilschaltbild einer dem in Figur 1 gezeigten ähnlichen Empfängerschaltungs 10 mit einem Komparator 26 zum Vergleichen der analogen Signalspannung 20 mit einer vorgegeben Schwellenspannung des Schwellwertgenerators 30 im Detail gezeigt. Diejenigen Elemente, die zu denen der oben in Verbindung mit Figur 1 beschriebenen Empfängerschaltung 10 ähnlich sind, sind mit denselben Bezugszeichen versehen, so dass bezüglich deren Beschreibung auf die Ausführungen dort Bezug genommen wird. Die Schwellenspannung des Schwellwertgenerators 30 ist bei dem in Figur 4 dargestellten Komparator 26 größer als ein als interne Spannungsquelle 48 veranschaulichter Komparator-Offset vorgegeben.

Die Schwellenspannung des Schwellwertgenerators 30 ist hier so vorgegeben, dass auch bei einem nach dem Datenblatt des Komparators 26 maximalen Komparator-Offset, welcher der Spannungs-Offset zuzüglich dem Produkt aus einem Strom-Offset und einem Quellwiderstand ist, ohne Lichtsignal kein Ausgangssignal am Ausgang 32 des Komparators 26 entsteht.

Solche Offsets können einerseits durch fertigungsbedingte systematische oder statistische Asymmetrien entstehen. Sie können sich durch Temperatureinflüsse, Änderung der Versorgungsspannung oder durch Alterung zeitlich langsam verändern und können daher nur teilweise durch einen Fertigungsabgleich kompensiert werden. Teure Präzisionskomparatoren erreichen hier gute, das heißt kleine, Offsetwerte; preiswerte Komparatoren sind hier deutlich schlechter. Besonders schlecht in dieser Hinsicht, aber auch besonders preiswert, sind in Mikrocontroller oder Mikroprozessoren integrierte analogelektrische Komparatoren. Durch den dort auf digitale Signale optimierten Halbleiterprozess und durch Störeinflüsse der digitalen Schaltung auf die empfindlichen Analogelemente lassen sich nur mäßige Offsetwerte erreichen.

Da das Vorzeichen des maximalen Komparator-Offsets bei Komparatoren der gleichen Art unterschiedlich sein kann und daher für den jeweils verwendeten Komparator 26 nicht von vornherein bekannt ist, muss die Schwellenspannung des Schwellwertgenerators 30 mindestens so groß vorgegeben werden, wie der Betrag des beispielsweise im Datenblatt des Komparators 26 angegebenen maximalen Komparator-Offsets, damit bei einem positiven Komparator-Offset nicht auch schon ohne Lichtimpuls, also ohne analoge Signalspannung 20, ein Signal am Ausgang 32 des Komparators 26 ausgegeben wird.

Damit der Komparator 26 den Lichtimpuls auch bei einem negativen maximalen Komparator-Offset erkennt, muss die garantierbare Mindest-Amplitude der analogen Signalspannung 20 das Doppelte des Betrages des maximalen Komparator-Offsets sein. Ist der Komparator-Offset viel kleiner als der im Datenblatt des Komparators 26 garantierte maximale Komparator-Offset, was typischerweise bei realen Komparatoren der Fall ist, entspricht die typische Empfindlichkeit des Komparators 26 für die Erkennung einer analogen Signalspannung 20 als Lichtimpuls der vorgegebenen Schwellenspannung des Schwellwertgenerators 30.

Beträgt der maximale Komparator-Offset beispielsweise ±50 mV, so wird eine Schwellenspannung des Schwellwertgenerators 30 von vorzugsweise 60 mV vorgegeben, damit auch bei dem maximalen positiven Komparator-Offset von +50 mV noch eine optische Mindest-Amplitude der analogen signalspannung 20 von 10 mV gewährleistet ist, wie sie erforderlich ist um die analoge Signalspannung 20 von kleinen Störspannungen, die von optischen und/oder elektrischen Störungen herrühren, unterscheiden zu können.

Die typische Schwellenspannung des Schwellwertgenerators 30, das heißt die typische Empfindlichkeit, wird dann bei dem Komparator-Offset nahe 0 mV, welcher am häufigsten auftritt, 60 mV betragen. Die geringste Empfindlichkeit ergibt sich entsprechend bei einem maximalen negativen Komparator-Offset von -50 mV zu dann insgesamt 110 mV. Damit ist die Empfängerschaltung 10 relativ unempfindlich. Bei einer kleineren Schwellenspannung des Schwellwert generators 30, welche eine entsprechend höhere Empfindlichkeit zur Folge hat, besteht dagegen stets die Gefahr, dass es bei einem großen positiven Komparator-Offset auch schon ohne Lichtimpulse zu einem dauerhaften Signal am Ausgang 32 des Komparators 26 kommt, und damit unabhängig von der Signalamplitude zu einem dauerhaften völligen Versagen der gesamten optischen Kommunikation.

Eine Verbesserung der Empfindlichkeit auch bei großen maximalen Komparator-Offsets lehrt hier die Erfindung, die im folgenden näher erläutert wird:

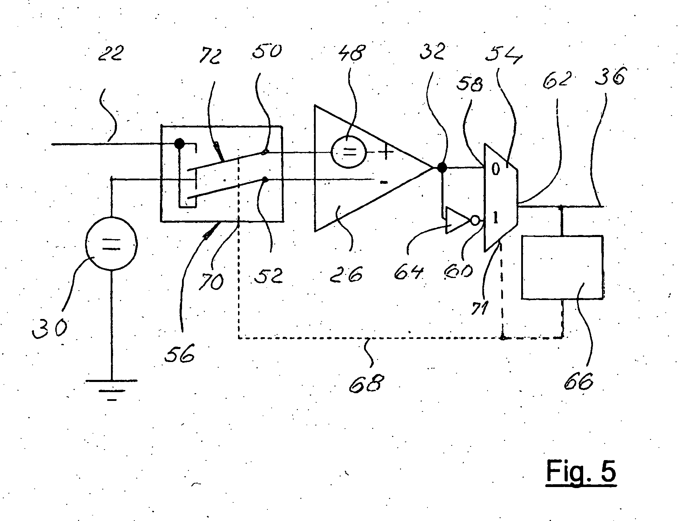

In Figur 5 ist schematisch ein Teilschaltbild eines ersten Ausführungsbeispiels einer Empfängerschaltung 10 einer erfindungsgemäßen Vorrichtung zur Datenübertragung mit der aus einem optischen Signal erzeugten analogen optoelektronischen Signalspannung 20 dargestellt.

Die Empfängerschaltung 10 umfasst einen dem in Figur 1 dargestellten ähnlichen Komparator 26. Ausgänge 50 und 52 einer Signalvertauschungseinrichtung 56 sind den Eingängen 24 beziehungsweise 28 des Komparators 26 vorgeschaltet. Mit der Signalvertauschungseinrichtung 56 ist die Polarität der analogen Eingangsspannung des Komparators 26 veränderbar.

Ein Digital-Umschalter 54 weist zwei Eingänge 58 und 60, und einen Signalausgang 62 auf. Der erste Eingang 58 des Digital-Umschalters 54 ist direkt mit dem Ausgang 32 des Komparators 26 verbunden. Dem zweite Eingang 60 ist ein NOT-Gatter 64 vorgeschaltet, dessen Eingang mit dem Ausgang 32 des Komparators 26 verbunden ist.

An die Leitung 36 ist ein Zeitüberwachungskreis 66 angeschlossen, der die Polarität seines Ausgangssignales immrer dann wechselt, wenn über eine vorgegebene, verglichen mit der Länge eines Datenwortes lange Zeit kein Signalwechsel auf der Binär-Signalleitung 36 beobachtet wird.

Der Ausgang des Zeitüberwachungskreises 66 ist über eine Steuerleitung 68 mit einem Steuereingang 70 der Signalvertauschungseinrichtung 56 und einem Steuereingang 71 des Digital-Umschalters 54 verbunden. Der Zeitüberwachungskreis 66 arbeitet genauer gesagt so, daß er dann sein Ausgangssignal ändert, wenn über die maximale Dauer-ZUSTANDS-Zeit (beim Ausführungsbeispiel maximale Dauer-EIN-Zeit) kein Signal erhalten wurde.

Der Signalausgang 62 führt über die Binär-Signalleitung 36 zu eine m nicht dargestellten Mikroprozessor des Verbrauchsmessgerätes. Am Signalausgang 62 liegt, wie am Ausgang 32 des Komparators 26, das umgewandelte binäre, ggf. invertierte, Signal 34 an.

Da der Digital-Umschalter 54 immer zusammen mit der Signalumpoleinrichtung 56 umgesteuert wird, hat man die selbe Polarität des Ausgangssignales unabhängig davon , ob man den positiven oder den negativen Ast der Kennlinie des Komparators 26 nutzt.

Mit dem Ausgangssignal des Zeitüberwachungskreises 66 ist somit der Steuereingang 70 der Signalvertauschungseinrichtung 56 beaufschlagbar, und so ist eine Umschaltung der Polarität der analogen Signalspannung 20 steuerbar.

Die Signalvertauschungseinrichtung 56 weist einen analogelektrischen Umpolschalter 72, vorzugsweise einen CMOS-Analog-schalter, beispielsweise einen Baustein HC4052, auf.

Die Vorgabe der externen Schwellenspannung des Schwellengenerators 30 bestimmt sich hier durch eine im Vergleich zu dem Komparator 26, der in Figur 4 dargestellt ist, verhältnismäßig kleine Spannung, beispielsweise 10 mV, womit die analoge Signalspannung 20 von Störungen unterschieden werden kann. Damit ergibt sich bei dem am häufigsten auftretenden Komparator-Offset nahe 0 mV eine sehr gute Empfindlichkeit, bei den oben in Zusammenhang mit Figur 4 lediglich beispielhaft gewählten Offset-Werten von etwa 10 mV.

Bei negativen Komparator-Offsets verringert sich zwar die Empfindlichkeit durch den sich daraus ergebenden größeren relativen Schwellwert, der sich aus der Schwellenspannung und dem Komparator-Offset zusammensetzt, etwas. Mit den oben in Verbindung mit den Ausführungen zu Figur 4 eingeführten beispielhaften Werten ergäbe sich dann eine garantierte Mindestempfindlichkeit von 60 mV anstelle von 110 mV, wie dies bei der Empfängerschaltung 10 aus Figur 4 ohne Signalvertauschungseinrichtung 56 der Fall ist. Eine solche eher seltene geringere Empfindlichkeit, welche auch einen reduzierten Kommunikationsabstand zur Folge hat, eines gerade noch in der Spezifikation bezüglich des maximalen Komparator-Offsets liegenden Ausreißerexemplars eines Komparators 26 ist aber insbesondere für eine Anwendung einer mobilen optischen Datenablesung von Verbrauchszählern akzeptabel.

Hat nun aber der Komparator 26 einen positiven Komparator-Offset,insbesondere einen größeren als die hier verhältnismäßig kleine Schwellenspannung des Schwellwertgenerators 30, so entsteht am Ausgang 32 des Komparators 26 ein Dauersignal. Da das optische Lichtsignal und damit die analoge Signalspannung 20 durch sein Bit- und/oder Byte-orientiertes Protokoll aber stets nach den sich aus der Übertragungsrate und dem Bit-orientierten Protokoll ergebenden Maximalzeiten logisch "Aus" sein muss beziehungsweise 0 V betragen muss, kann aus einem länger als diese Maximalzeit andauernd aktiven Ausgangssignal am Ausgang 32 des Komparators 26 geschlossen werden, dass ein zu großer positiver Komparator-Offset vorliegt, welcher das Vorliegen einer einen Lichtimpuls charakterisierenden analoge Signalspannung 20 vortäuscht.

Nun wird durch den Zeitüberwachungskreis 66 die Signalvertauschungseinrichtung 56 angesteuert und mit dieser die Polarität der analogen Signalspannung 20 an den Eingängen 24 und 28 des Komparators 26 gewechselt. Durch die damit geänderte logische Polarität und durch eine mit dem Umpolschalter 72 gekoppelte Digitalinversion des digitalen Ausgangssignales 32 des Komparators 26 sind nun die Arbeitsbedingungen so geändert, daß statt des positiven Komparator-Offsets der negative Komparator-Offset zum Tragen kommt. In Folge verschwindet das daueraktive Ausgangssignal am Ausgang 32 des Komparators 26 und es wird wieder eine normale Funktion und Empfindlichkeit des Komparators 26 erhalten.

Ist der Komparator-Offset zwar positiv aber kleiner als die Schwellenspannung 30, so erhöht sich zunächst nur die Empfindlichkeit. Ist der positive Komparator-Offset des verwendeten Komparators 26 dagegen etwa so groß wie die Schwellenspannung 30, so entsteht am Ausgang 32 des Komparators 26 noch kein daueraktives Ausgangssignal. Die Empfängerschaltung ist aber sehr empfindlich gegenüber optischen und elektrischen Störungen. Führt eine solche Störung zu Bitfehlern, so wird dies spätestens auf einer Protokoll-Sicherungsschicht als Bitfehler oder als Timing-Fehler erkannt. In diesem Fall wird dann versuchsweise der Umpolschalter 72 und der Umschalter 54 in die jeweils andere Stellung umgeschaltet und die Kommunikation wiederholt.

Der einmal zu einer erfolgreichen Signalumwandlung führende Umschaltzustand des Umpolschalters 72 kann mit einem nicht dargestellten Flipflop gespeichert werden. Die nächste Kommunikation wird dann mit dem erlernten Umpolzustand gestartet, da sich das Vorzeichen des Komparator-Offsets,wenn überhaupt, später nur sehr langsam ändert. Dadurch wird es meist nur einmal, auf jeden Fall aber sehr selten, zu einem solchen Fehlversuch mit nachfolgender Wiederholung mit invertierter Empfangspolarität des Komparators 26 kommen.

Insgesamt ergibt sich also mit den oben eingeführten beispielhaften Zahlenwerten eine Verbesserung der typischen Empfindlichkeit für einen Komparator-Offset nahe 0 mV gegenüber einer Schaltung des Komparators 26 ohne Signalumpolung, wie er in den Figur 4 dargestellt ist, um einen Faktor sechs, nämlich 10 mV statt 60 mV, und eine Verbesserung der garantierten Empfindlichkeit für einen maximalen Komparator-Offset von 50 mV etwa um einen Faktor zwei, nämlich 60 mV statt 110 mV. Trotzdem kommt es auch bei einem großen Komparator-Offset nie zu einer Dauerblockade der optischen Kommunikation für eine so hohe Empfindlichkeit, wie dies bei der Schaltung des Komparators 26 ohne Signalumpolung der Fall ist.

Eine ähnliche, nicht dargestellte Kombination eines preiswerten Komparators 26 mit einer integrierten Signalvertauschungseinrichtung 56 (Umpolender Komparator) ist beispielsweise bei bekannten Mikrocontrollern oder Mikroprozessoren, insbesondere bei einer Mikrocontroller-Baureihe mit der Bezeichnung MSP430 der Firma von Texas Instruments, implementiert.

Statt gesteuert durch den Zeitüberwachungskreis 66 kann der Umpolschalter 72 die Polarität der analogen Signalspannung 20 auch gesteuert durch eine Software, insbesondere eine Auswertesoftware, eines Mikroprozessors oder eines Mikrocontrollers wechseln.

Der einmal erreichte Umschaltzustand des Umpolschalters 72 kann statt mit dem nicht dargestellten Flipflop auch mit der Software des Mikroprozessors oder Mikrocontrollers gespeichert werden.

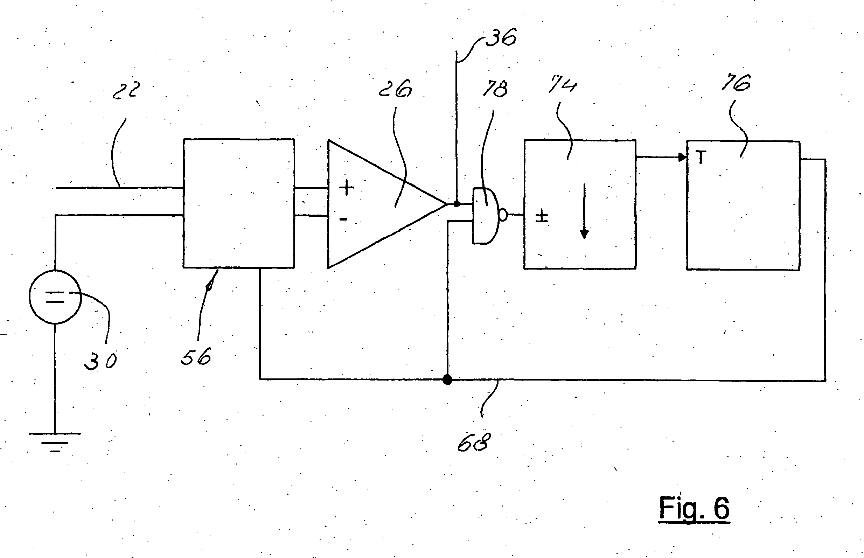

In Figur 6 ist schematisch ein Teilschaltbild eines zweiten Ausführungsbeispiels einer der Empfängerschaltung von Figur 5 ähnlichen, Empfängerschaltung 10 dargestellt. Bei dem zweiten Ausführungsbeispiel sind diejenigen Elemente, die zu denen des ersten, in Figur 5 beschriebenen Ausführungsbeispiels ähnlich sind, mit denselben Bezugszeichen versehen, so dass bezüglich deren Beschreibung auf die Ausführungen zum ersten Ausführungsbeispiel Bezug genommen wird.

Dieses Ausführungsbeispiel unterscheidet sich von dem ersten dadurch, dass eine Signalvertauschungseinrichtung 56 statt über den Zeitüberwachungskreise 66 über ein retriggerbares Monoflop 74 und ein Toggle-Flipflop 76 mit dem Ausgang 32 des Komparators 26 steuerbar verbunden ist.

Der Ausgang 32 des Komparators 26 ist hierbei mit einem ersten Eingang eines NAND-Gatters 78 verbunden. Der zweite Eingang des NAND-Gatters 78 ist gleichzeitig mit einem Ausgang des Toggle-Flipflops 76 und dem Steuereingang 70 der Signalvertauschungseinrichtung 56 verbunden. Vom Ausgang des NAND-Gatters 78 führt eine Leitung zum Eingang des Monoflops 74. Dessen Ausgang ist mit einem Eingang des Toggle-Flipflops 76 verbunden.

Ein Überschreiten der maximalen Dauer-ZUSTANDS-Zeit eines Ausgangssignals am Ausgang 32 des Komparators 26 wird mit dem retriggerbaren Monoflop 74 und dem Toggle-Flipflop 76 erfasst. Daraufhin wird die Signalvertauschungseinrichtung 56 über den Ausgang des Toggle-Flipflops 76 entsprechend angesteuert und die Polarität der analogen Signalspannung 20 so geändert.

Insbesondere bei gepulsten Bit-orientierten Protokollen, wie beispielsweise beim IrDA-Protokoll, lässt sich sowohl der konstante, als auch der zeitlich langsam variable Störsignalanteil der analogen Signalspannung 20 bei den folgenden, zu dem ersten und zweiten Ausführungsbeispielen ähnlichen Ausführungsbeispielen, eliminieren:

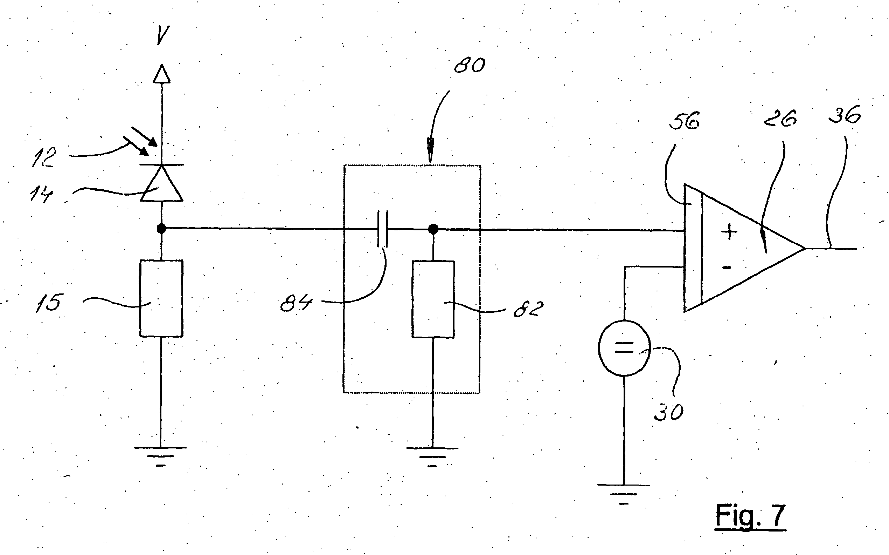

In Figur 7 ist schematisch ein Teilschaltbild eines dritten Ausführungsbeispiels einer Empfängerschaltung 10 einer Vorrichtung zur Datenübertragung mit einem analogen optoelektronischen Signal dargestellt. Diejenigen Elemente, die zu denen des ersten und des zweiten, in Figuren 5 beziehungsweise 6 dargestellten, Ausführungsbeispielen ähnlich sind, sind mit denselben Bezugszeichen versehen, so dass bezüglich deren Beschreibung auf die Ausführungen zum ersten beziehungsweise zweiten Ausführungsbeispiel Bezug genommen wird.

Die Empfängerschaltung 10 weist einen Hochpassfilter 80 zum Filtern der analogen Signalspannung 20 auf. Darüber hinaus weist er eine umpolende Komparator-Einheit 26 mit einer en Signalvertauschungseinrichtung 56 zum Umpolen der Polarität auf, die dem gleichen Zweck dient und genauso arbeitete wie die Signalvertauschungseinrichtung 56 nach den Ausführungsbeispielen von Figur 5 beziehungsweise Figur 6.

Eine Leitung zwischen der Fotodiode 14 und dem mit der Masse verbundenen Widerstand 15 ist mit einem ersten Anschluss eines Kondensators 84 des analogelektrischer Hochpassfilters 80 in Form eines RC-Glieds verbunden. Ein zweiter Anschluss des Kondensators 84 ist über einen zugleich als Ausgang des Hochpassfilters 80 dienenden Knoten sowohl mit einem ersten Anschluss eines Hochpass-Widerstandes 82 des Hochpassfilters 80 als auch mit einem ersten Eingang des umpolenden Komparators 26 verbunden. Die Zeitkonstante des Hochpassfilters 80 ist so vorgegeben, dass langsam veränderliche Störeinflüsse von der analogen Signalspannung 20 abgetrennt werden und diese so gefiltert wird.

Der erste Eingang des umpolenden Komparators 26 ist so mit der gefilterten analogen Signalspannung 20 beaufschlagt. Der andere Eingang des umpolenden Komparators 26 ist mit dem Ausgang des Schwellwertgenerators 30 verbunden und ist so mit der Schwellenspannung beaufschlagt.

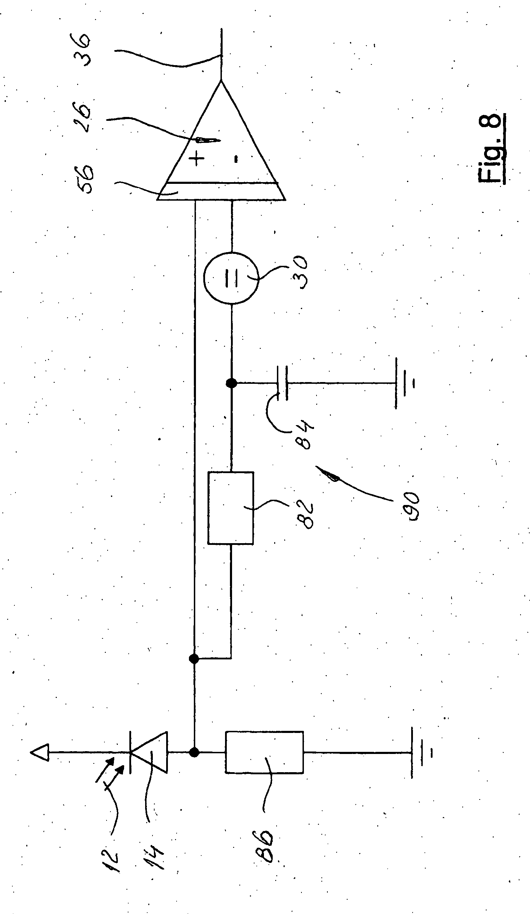

In Figur 8 ist schematisch ein Teilschaltbild eines vierten Ausführungsbeispiels einer Empfängerschaltung 10 einer Vorrichtung zur Datenübertragung mit einem analogen optoelektronischen Signal dargestellt. Diejenigen Elemente, die zu denen des dritten, in Figur 7 dargestellten, Ausführungsbeispiels ähnlich sind, sind mit denselben Bezugszeichen versehen, so dass bezüglich deren Beschreibung auf die Ausführungen zum dritten Ausführungsbeispiel Bezug genommen wird.

Bei der Empfängerschaltung 10 gemäß dem vierten Ausführungsbeispiel ist ein Tiefpass 90 mit dem Schwellwertgenerator 30 in Reihe geschaltet dem zweiten Eingang des umpolenden Komparators 26 aus Figur 7 vorgeschaltet. Im Unterschied zum dritten, in Figur 7 beschriebenen Ausführungsbeispiel, ist die Leitung zwischen der Fotodiode 14 und dem mit Masse verbundenen Widerstand 15 über eine erste Verzweigung direkt mit dem ersten Eingang des umpolenden Komparators 26 verbunden.

Von einem Tiefpass-Widerstand 82 führt eine weitere Leitung zu einem ersten Anschluss eines Tiefpass-Kondensators 84. Der zweite Anschluss des Kondensators 94 liegt auf Masse. Der zwischen Tiefpass-Widerstand 82 und Tiefpass-Kondensator 84 liegende Knoten ist zugleich der Ausgang des Tiefpasses 90.

An dem Auslaß des Tiefpasses 90 hängt die eine Klemme des Schwellwertgenerators 30. Von dessen zweiter Klemme führt eine Leitung zum zweiten Eingang des umpolenden Komparators 26.

Auf diese Weise wird die am Ausgang des Tiefpasses 90 anliegende geglättete analoge Signalspannung 20 zu der Schwellenspannung 30 hinzuaddiert, so dass Langzeitdrifts der Signalspannung 20 mit kompensiert werden.

Beim Empfang eines binär kodierten optischen Signals wird die analoge Signalspannung 20, welche mit Gleichlichtbedingten Komponenten und Störkomponenten überlagert sein kann, direkt auf den ersten Eingang des umpolenden Komparators 26 gegeben. Gleichzeitig wird mit dem Tiefpass 90 der Mittelwert der analogen Signalspannung 20 gebildet, diese also geglättet oder gemittelt. Zu der geglätteten analogen Signalspannung 20 wird dann analogelektrisch die Schwellenspannung 30 addiert und die Summe beider Spannungen auf den zweiten Eingang des selbst umpolenden Komparators 26 gegeben.

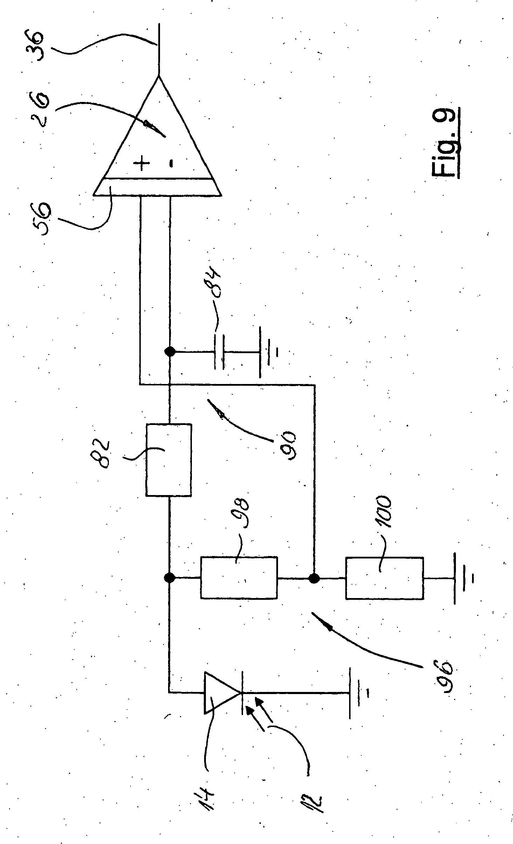

In Figur 9 ist schematisch ein Teilschaltbild eines fünften Ausführungsbeispiels einer integrierten Empfängerschaltung 10 einer Vorrichtung zur Datenübertragung mit einem analogen optoelektronischen Signal dargestellt. Diejenigen Elemente, die zu denen des vierten, in Figur 8 beschriebenen Ausführungsbeispiel ähnlich sind, sind mit denselben Bezugszeichen versehen, so dass bezüglich deren Beschreibung auf die Ausführungen zum vierten Ausführungsbeispiel Bezug genommen wird.

Bei dem fünften Ausführungsbeispiel ist die Fotodiode 14 mit einem ihrer Anschlüsse auf Masse gelegt und mit ihrem anderen Anschluss über einen ersten Knoten mit einem ersten Anschluss eines ersten Spannungsteiler-Wider-standes 98 eines Spannungsteilers 96 verbunden. Der zweite Anschluss des ersten Spannungsteiler-Widerstandes 98 ist über einen zweiten Knoten, welcher als Abgriff des Spannungsteilers 96 wirkt, mit einem ersten Anschluss eines zweiten Spannungsteiler-Widerstandes 100 verbunden. Der zweite Anschluss des zweiten Spannungsteiler-Widerstandes 100 liegt auf Masse.

Der zweite Knoten ist außerdem direkt mit dem ersten Eingang der Signalumpolung-Komparator-Anordnung 26 verbunden.
Ferner führt von dem ersten Knoten eine Verbindung zu einem ersten Anschluss eines Tiefpass-Widerstandes 82, der zu einem als Tiefpass 90 wirkenden RC-Glied gehört. Der zweite Anschluss des Tiefpass-Widerstandes 82 führt über einen dritten Knoten, welcher als Ausgang des Tiefpasses 90 dient, zu dem zweiten Eingang des umpolenden Komparators. Der dritte Knoten ist darüber hinaus über den Kondensator 84 des Tiefpasses 90 mit der Masse verbunden.

Bei der Vorrichtung gemäß dem fünften Ausführungsbeispiel wird die Fotodiode 14 im Generatormodus betrieben und die so erzeugte Spannung, welche beispielsweise im Bereich von 0,4 V bis 0,8 V, aber auch darunter oder darüber liegen kann, als analoge Signalspannung 20 eingesetzt. Die so erzeugte analoge Signalspannung 20 wird zunächst einem Spannungsteiler 96 zugeführt. Das Verhältnis der Werte von Spannungsteiler-Widerständen 98 und 100 ist so vorgegeben, dass beispielhaft etwa 98% der analogen Signalspannung 20 an dem Abgriff des Spannungsteilers anliegen und damit an dem ersten Eingang des umpolenden Komparators 26 angelegt sind. Der Spannungsteiler 96 kann auch ein anderes Spannungsteilungsverhältnis aufweisen.

Die ungeteilte analoge Signalspannung 20 wird über den Tiefpass 90, mit dem der Mittelwert der analogen Signalspannung 20 gebildet, diese also geglättet wird, an den zweiten Eingang des umpolenden Komparators 26 angelegt. So wird die effektive, in Figur 9 nicht gezeigte, Schwellenspannung bei den hier lediglich beispielhaft gewählten Zahlenwerten mit 2% der je nach Grundlicht, also Intensität des vom Sender kommenden Lichts, im Bereich von 0,4 V bis 0,8 V liegenden analogen Signalspannung 10, also mit 8 mV bis 16 mV, vorgegeben.

Die Empfängerschaltungen 10 können statt mit einem Verbrauchsmessgerät auch mit einem andersartigen mobilen oder ortsfesten elektronischen Gerät mit Netz- oder Batteriebetrieb, insbesondere mit einem Mobiltelefon, einem mobilen oder ortsfesten Rechner, insbesondere einem Notebook oder einem PC, verbunden oder in dieses integriert sein.

Anstelle des analogen Komparators 26 kann auch ein andersartiges Vergleicher-Mittel, auch in Form einer entsprechenden Software und/oder Schaltung eines Mikroprozessors, zum Vergleichen des analogen Signals, insbesondere der analogen Signalspannung 20 Verwendung finden. Anstelle der Signalspannung 20 und der Schwellenspannung 30 können dann auch andersartige Signal- beziehungsweise #Schwellwerte, beispielsweise Ströme oder Widerstände, miteinander verglichen werden.

Statt der infraroten Lichtsignale können mit entsprechenden Senderbauelementen und Empfängerbauelementen auch andersartige, insbesondere sichtbare, Lichtsignale oder auch Funksignale zur Kommunikation eingesetzt werden.

Das Lichtsignal kann statt binär auch über eine andere vorgegebene begrenzte Dauer-ZUSTANDS-Zeit auch andersartig kodiert sein. Das Lichtsignal kann statt in ein binäres Signal 34 auch in ein anderes digitales Signal umgewandelt werden.

Die Empfängerschaltung 10 kann statt der Fotodiode 14 ein andersartiges Empfängerbauelement, insbesondere einen Fotowiderstand, einen Fototransistor oder eine Fotozelle augfweisen.

Die Empfängerschaltung 10 kann auch mit einem Sendebaustein, der beispielsweise eine Infrarot-LED aufweist, die einen eingebauten Impulsformer umfaßt, in einen optoelektronischen Transceiverbaustein integriert sein. Im Sender kann dann auch eine bekannte schaltbare Konstantstromquelle integriert sein. Durch paarweise Anordnung von solchen optoelektronischen Transceiverbausteinen ist eine komplette bidirektionale Übertragungsstrecke mit einer Reichweite wenigstens im Bereich von 2 m realisierbar.

Statt mit dem den Schwellwertgenerator 30 bildenden Spannungsteiler aus der Geräte-Versorgungsspannung des Verbrauchsmessgerätes kann auch mit einer anderen Spannungsquelle die Schwellenspannung vorgegeben werden.

## Patentansprüche

1. Verfahren zur Datenübertragung, bei dem wenigstens ein impulsförmiges analoges Signal (20), welches übertragene digitale Daten mit vorgegebener begrenzter ZUSTANDS-Zeit charakterisiert, in ein digitales Signal umgewandelt wird, bei dem
a) das analoge Signal (20) mit einem vorgegebenen analogen Schwellwert (30) verglichen wird und ein binäres Ausgangssignal (34) solange erzeugt wird, solange der Vergleich ergibt, dass die Amplitude des analogen Signals (20) größer als der Schwellwert (30) ist,
b) das analoge Signal (20) und der Schwellwert (30) vertaucht werden können, um den Einfluss von Störsignalen, insbesondere Driftsignalen, zu vermindern,
**dadurch gekennzeichnet, dass**
c) das Vertauschen von analogem Signal (20) und Schwellwert (30) dann durchgeführt wird, wenn das binäre Ausgangssignal (34) länger erzeugt wird als eine vorgegebene maximale Dauer-ZUSTANDS-Zeit für das binäre Ausgangssignal (34).

2. Verfahren nach Anspruch 1, **dadurch gekennzeichnet, dass** das analoge Signal (20) mit einem analogelektrischen Komparator (26) mit dem analogen Schwellwert (30) verglichen wird und das Vertauschen von analogem Signal (20) und Schwellwert (30) mit einer steuerbaren Signalvertauschungseinrichtung (56) durchgeführt wird.

3. Verfahren nach Anspruch 1 oder 2, **dadurch gekennzeichnet, dass** die Datenübertragung mit Bit- und/oder Byte-orientierten Protokollen organisiert wird.

4. Verfahren nach Anspruch 3, **dadurch gekennzeichnet, dass** die maximale Dauer-ZUSTANDS-Zeit von dem Bit- und/oder Byte-orientierten Protokoll vorgegeben wird.

5. Verfahren nach einem der Ansprüche 1 bis 4, **dadurch gekennzeichnet, dass** eine Überschreitung der maximalen Dauer-ZUSTANDS-Zeit mit einem retriggerbaren Monoflop (74) und einem nachgeschalteten Flipflop (76) erkannt wird.

6. Verfahren nach einem der Ansprüche 1 bis 4, **dadurch gekennzeichnet, dass** eine Überschreitung der maximalen Dauer-ZUSTANDS-Zeit und eine Änderung der Polarität des analogen Signals (20) durch eine Digitalschaltung (54, 66) oder eine Software eines Mikrocontrollers oder Mikroprozessors realisiert wird.

7. Verfahren nach Anspruch 6, **dadurch gekennzeichnet, dass** die Überschreitung der maximalen Dauer-ZUSTANDS-Zeit und die Änderung der Polarität des analogen Signals (20) durch einen dem Komparator (26) nachgeschalteten oder in den Komparator (26) und/oder die analogelektrische Signalvertauschungseinrichtung (56) integrierten Zeitüberwachungskreis (66) realisiert wird.

8. Verfahren nach Anspruch 6 oder 7, **dadurch gekennzeichnet, dass** zur Änderung der Polarität des analogen Signals (20) das binäre Ausgangssignal (34) insbesondere mit der Digitalschaltung (54, 66) oder der Software des Mikrocontrollers oder Mikroprozessors invertiert wird und mit dem invertierten Ausgangssignal die Änderung der Polarität des analogen Signals (20) realisiert wird, indem die analogelektrische Signalvertauschungseinrichtung (56) entsprechend angesteuert wird.

9. Verfahren nach einem der vorhergehenden Ansprüche, **dadurch gekennzeichnet, dass** die geänderte Polarität des analogen Signals (20) bis zu einer weiteren Überschreitung der maximalen Dauer-ZUSTANDS-Zeit oder bis zur Erkennung eines Fehlers bei der Datenübertragung, insbesondere eines Fehlers im Bit- und/oder Byte-orientierten Protokoll, oder bis zur Erkennung eines Timingfehlers oder bis zu einer Kommunikationspause beibehalten wird.

10. Verfahren nach einem der Ansprüche 2 bis 9, **dadurch gekennzeichnet, dass** die Änderung der Polarität des analogen Signals (20) mit einem entsprechenden Wechsel eines Logikpegels des binären Signals (34) gekoppelt ist.

11. Verfahren nach einem der vorhergehenden Ansprüche, **dadurch gekennzeichnet, dass** für den analogen Schwellwert (30) ein Wert vorgegeben wird, der kleiner ist als ein maximaler Offset einer Komponente einer zur Durchführung des Verfahrens verwendeten Hardware, insbesondere eines Vergleicher-Bauteils (26), mit dem das analoge Signal (20) mit dem Schwellwert (30) verglichen wird.

12. Verfahren nach einem der vorhergehenden Ansprüche, **dadurch gekennzeichnet, dass** gegebenenfalls enthaltene konstante oder langsam veränderliche Störanteile aus dem analogen Signal (20) insbesondere mit einem geeigneten analogelektrischen Filter, insbesondere einem Hochpassfilter (80), vorzugsweise einem RC-Glied, zumindest teilweise eliminiert werden, bevor das analoge Signal (20) mit dem analogen Schwellwert (30) verglichen wird beziehungsweise bevor seine Polarität geändert wird.

13. Verfahren nach einem der Ansprüche 1 bis 11, **dadurch gekennzeichnet, dass** das analoge Signal mit der Summe aus dem Schwellwert und dem geglätteten analogen Signal verglichen wird, insbesondere eine analoge Signalspannung (20) auf einen der beiden Eingänge der Signalvertauschungseinrichtung (56) und auf den anderen Eingang der Signalvertauschungseinrichtung (56) die durch einen Tiefpass (90), insbesondere ein RC-Glied, geglättete analoge Signalspannung (20) gegeben wird, vorzugsweise zuzüglich einer analogen Schwellwertspannung.

14. Verfahren nach einem der Ansprüche 1 bis 11, **dadurch gekennzeichnet, dass** der Schwellwert als geglättete Amplitude des analogen Signals bestimmt wird und mit einem Bruchteil des nicht geglätteten analogen Signal verglichen wird, insbesondere ein Spannungsbruchteil (98, 100) der analogen Signalspannung (20) auf einen der beiden Eingänge der Signalvertauschungseinrichtung (56) gegeben wird, der der Komparator (26) nachgeschaltet ist, und auf den anderen Eingang der Signalvertauschungseinrichtung (56) die insbesondere mit einem Tiefpass (90) geglättete analoge Signalspannung (20) gegeben wird.

15. Verfahren nach einem der vorhergehenden Ansprüche, **dadurch gekennzeichnet, dass** die Daten, insbesondere die Datenbits, der Datenübertragung durch Impulse mit einer mittleren Impulslänge von weniger als 25% einer Bitzeit kodiert werden.

16. Verfahren nach einem der vorhergehenden Ansprüche, **dadurch gekennzeichnet, dass** die Daten, insbesondere die Datenbits, entsprechend der Quasinorm mit der Bezeichnung "IrDA" impulskodiert werden.

17. Verfahren nach einem der Ansprüche 1 bis 14, **dadurch gekennzeichnet, dass** die Daten, insbesondere Datenbytes, entsprechend der ZVEI-Norm IEC 1107 kodiert werden.

18. Verfahren nach einem der vorhergehenden Ansprüche, **dadurch gekennzeichnet, dass** die Daten zwischen mindestens einem mobilen Gerät und einem ortsfesten oder zwischen zwei mobilen Geräten übertragen werden.

19. Verfahren nach einem der vorhergehenden Ansprüche, **dadurch gekennzeichnet, dass** die Daten von und/oder zu einem insbesondere ortsfesten Verbrauchszähler, insbesondere einem Heizkosten-Verteiler oder einem Strom-, Gas-, Wasser- oder Wärmemengenzähler, übertragen werden.

20. Verfahren nach einem der Ansprüche 1 bis 19, **dadurch gekennzeichnet, daß** das analoge Signal (20) auf opto-elektronischem Weg erzeugt werden.

21. Vorrichtung zur Datenübertragung wenigstens eines impulsförmigen analogen Signales (20), welches zu übertragende Daten mit vorgegebener begrenzter ZUSTANDS-Zeit charakterisiert, mit einem Umwandler zur Umwandlung des analogen Signals in ein digitales Signal, der aufweist:
a) ein Mittel (26) zum Vergleichen des analogen Signals (20) mit einem vorgegebenen analogen Schwellwert (30) und zur Erzeugung eines binären Ausgangssignals (34) dann, wenn die Amplitude des analogen Signals (20) größer als der analoge Schwellwert (30) ist;
b) eine steuerbare analogelektrische Signalvertauschungseinrichtung (56), mit der das analoge Signal (20) und der analoge Schwellwert (30) vertauschbar sind; und
c) einen Zeitüberwachungskreis (66, 74-78), welcher die Signalvertauschungseinrichtung bei Vorliegen einer Störung jeweils in den anderen Schaltzustand stellt;
**dadurch gekennzeichnet,**
d) **dass** der Zeitüberwachungskreis (66, 74-78) die Signalvertauschungseinrichtung (56) dann in den jeweils anderen Schaltzustand steuert, wenn die ZUSTANDS-Zeit des binären Ausgangssignales (34) die maximale Dauer-ZUSTANDS-Zeit erreicht.

22. Vorrichtung nach Anspruch 21, **dadurch gekennzeichnet, dass** das Vergleicher-Mittel ein analogelektrischer Komparator (26) ist und wenigstens ein Ausgang der Signalvertauschungseinrichtung (56) wenigstens einem Eingang des Komparators (26) vorgeschaltet ist.

23. Vorrichtung nach Anspruch 21 oder 22, **dadurch gekennzeichnet, dass** die Datenübertragung mit Bit- und/oder Byte-orientierten Protokollen organisiert ist.

24. Vorrichtung nach Anspruch 23, **dadurch gekennzeichnet, dass** die begrenzte Dauer-ZUSTANDS-Zeit und die maximale Dauer-ZUSTANDS-Zeit von dem Bit- und/oder Byte-orientierten Protokoll vorgegeben sind.

25. Vorrichtung nach einem der Ansprüche 21 bis 24, **dadurch gekennzeichnet, dass** dem Umwandler, insbesondere dem Vergleicher-Mittel (26), ein retriggerbares Monoflop (74) und ein Flipflop (76) zur Erfassung einer Überschreitung der maximalen Dauer-ZUSTANDS-Zeit nachgeschaltet sind.

26. Vorrichtung nach einem der Ansprüche 21 bis 25, **dadurch gekennzeichnet, dass** eine Digitalschaltung oder ein Mikrocontroller oder Mikroprozessor mit einer Software zur Erfassung der Überschreitung der maximalen Dauer-ZUSTANDS-Zeit und zur Änderung der Polarität des analogen Signals (20), insbesondere eine dem Vergleicher-Mittel (26) nachgeschaltete oder in das Vergleicher-Mittel (26) und/oder in die Signalvertauschungseinrichtung (56) integrierte Zeit-Überwachungsschaltungschaltung (66) oder ein Mikrocontroller oder Mikroprozessor, vorgesehen ist.

27. Vorrichtung nach Anspruch 26, **dadurch gekennzeichnet, dass** die Zeit-Überwachungsschaltung (66) beziehungsweise die Software des Mikrocontrollers oder Mikroprozessors ein Mittel (54) zum Invertieren des binären Ausgangssignals (34) aufweist und die analogelektrische Signalvertauschungseinrichtung (56) mit der Zeit-Überwachungs-schaltung (66) beziehungsweise dem Mikrocontroller oder Mikroprozessor zur Änderung der Polarität des analogen Signals (20) steuerbar verbunden ist.

28. Vorrichtung nach einem der Ansprüche 21 bis 27, **gekennzeichnet durch** ein Speichermittel, insbesondere einen Mikrocontroller oder Mikroprozessor mit einer Software oder ein Flipflop (76) zum Halten der geänderten Polarität des analogen Signals (20) bis zu einer weiteren Überschreitung der maximalen Dauer-ZUSTANDS-Zeit oder bis zur Erkennung eines Fehlers bei der Datenübertragung, insbesondere eines Fehlers im Bit- beziehungsweise Byte-orientierten Protokoll, oder bis zur Erkennung eines Timingfehlers oder bis zu einer Kommunikationspause.

29. Vorrichtung nach einem der Ansprüche 21 bis 28, **dadurch gekennzeichnet, dass** die Änderung der Polarität des analogen Signals (20) mit einem entsprechenden Wechsel eines Logikpegels des binären Signals (34) am Ausgang des Vergleicher-Mittels (26) gekoppelt ist.

30. Vorrichtung nach einem der Ansprüche 21 bis 29, **dadurch gekennzeichnet, dass** der analoge Schwellenwert (30) kleiner ist als ein maximaler Offset des Vergleicher-Mittels, insbesondere des Komparators (26), insbesondere das analoge Signal (20) an einem ersten Eingang (24) des Vergleicher-Mittels (26) und der analoge Schwellwert (30) an einem zweiten Eingang (28) des Vergleicher-Mittels (26) anliegt.

31. Vorrichtung nach einem der Ansprüche 21 bis 30, **dadurch gekennzeichnet, dass** dem Vergleicher-Mittel (14) und/oder der analogelektrischen Signalvertauschungseinrichtung (56) ein geeignetes analogelektrisches Filter, insbesondere ein Hochpassfilter, vorzugsweise ein RC-Glied (80), zum zumindest teilweisen Eliminieren gegebenenfalls enthaltener konstanter oder langsam veränderlicher Störanteile aus dem analogen Signal (20), vorgeschaltet ist.

32. Vorrichtung nach einem der Ansprüche 21 bis 31, **dadurch gekennzeichnet, dass** dem Vergleicher-Mittel (26) und/oder der analogelektrischen Signalvertauschungseinrichtung (56) ein Mittel zur Glättung des analogen Signals (20), insbesondere ein Tiefpass (90), vorzugsweise ein RC-Glied, und ein Mittel zum Addieren des Schwellwertes (30) und des am Ausgang des Tiefpasses (90) anliegenden geglätteten analogen Signals (20) vorgeschaltet sind, insbesondere das analoge Signal (20) gleichzeitig an einem der beiden Eingänge der Signalvertauschungseinrichtung (56) mit dem nachgeschalteten Vergleicher-Mittel (26) und am Eingang des Tiefpasses (90) anliegt, wobei der Tiefpass (90) und ein Mittel (30) zur Erzeugung einer den analogelektrischen Schwellwert charakterisierenden Schwellenspannung dem anderen Eingang der Signalvertauschungseinrichtung (56) in Reihe vorgeschaltet sind.

33. Vorrichtung nach einem der Ansprüche 21 bis 30, da durch gekennzeichnet, dass einem ersten Eingang (24) des Vergleicher-Mittels (26) und/oder der analogelektrischen Signalvertauschungseinrichtung (56) ein Mittel (96) zur Bildung eines Amplitudenbruchteils des analogen Signals (20), insbesondere ein Spannungsteiler (96), vorgesehen ist und einem zweiten Eingang (28) des Vergleicher-Mittels (26) und/oder der analogelektrischen Signalvertauschungseinrichtung (56) ein Mittel zur Glättung des analogen Signals (20), insbesondere ein Tiefpass (90), vorgeschaltet ist.

34. Vorrichtung nach einem der Ansprüche 21 bis 33, da durch gekennzeichnet, dass die Daten, insbesondere die Datenbits, der Datenübertragung Impulse mit einer mittleren Dauer von weniger als 25% einer Bitzeit umfassen.

35. Vorrichtung nach einem der Ansprüche 21 bis 34, **dadurch gekennzeichnet, dass** die Daten, insbesondere die Datenbits, entsprechend der Quasinorm mit der Bezeichnung "IrDA" impulskodiert sind.

36. Vorrichtung nach einem der Ansprüche 21 bis 35, **dadurch gekennzeichnet, dass** die Daten, insbesondere Datenbytes, entsprechend der ZVEI-Norm IEC 1107 kodiert sind.

37. Vorrichtung nach einem der Ansprüche 21 bis 36, **dadurch gekennzeichnet, dass** sie mit einem mobilen Gerät oder einem ortsfesten Gerätes funktionell verbunden oder in dieses integriert ist.

38. Vorrichtung nach einem der Ansprüche 21 bis 37, **dadurch gekennzeichnet, dass** sie insbesondere mit einem ortsfesten Verbrauchszähler, insbesondere einem Heizkosten-Verteiler oder einem Strom-, Gas-, Wasser- oder Wärmemengenzähler, funktionell verbunden oder in diesen integriert ist.

39. Vorrichtung nach einem der Ansprüche 21 bis 38, **dadurch gekennzeichnet, dass** das analoge Signal (20) von der Ausgangsspannung eines lichtempfindlichen Wandlers (14) abgeleitet ist, welcher Teil eines Optokopplers einer optischen Datenübertragungsstrecke ist.

## Claims

1. Method for transmitting data, wherein at least one pulsiform analogue signal (20), which characterises transmitted digital data having predetermined limited STATE time, is converted into a digital signal, wherein
a) the analogue signal (20) is compared with a predetermined analogue threshold value (30), and a binary output signal (34) is generated so long as the comparison shows that the amplitude of the analogue signal (20) is greater than the threshold value (30),
b) the analogue signal (20) and the threshold value (30) can be interchanged, in order to diminish the influence of interfering signals, in particular drift signals,
**characterised in that**
c) the interchanging of analogue signal (20) and threshold value (30) is carried out when the binary output signal (34) is generated for longer than a predetermined maximal steady-STATE time for the binary output signal (34).

2. Method according to Claim 1, **characterised in that** the analogue signal (20) is compared with the analogue threshold value (30) using an analogue electrical comparator (26), and the interchanging of analogue signal (20) and threshold value (30) is carried out with a controllable signal-interchange device (56).

3. Method according to Claim 1 or 2, **characterised in that** the data transmission is organised using bit-oriented and/or byte-oriented protocols.

4. Method according to Claim 3, **characterised in that** the maximal steady-STATE time is predetermined by the bit-oriented and/or byte-oriented protocol.

5. Method according to one of Claims 1 to 4, **characterised in that** an exceeding of the maximal steady-STATE time is detected with a retriggerable monoflop (74) and with a downstream flip-flop (76).

6. Method according to one of Claims 1 to 4, **characterised in that** an exceeding of the maximal steady-STATE time and a change in the polarity of the analogue signal (20) are realised by a digital circuit (54, 66) or by software of a microcontroller or microprocessor.

7. Method according to Claim 6, **characterised in that** the exceeding of the maximal steady-STATE time and the change in the polarity of the analogue signal (20) are realised by a time-monitoring circuit (66) connected downstream of the comparator (26) or integrated into the comparator (26) and/or into the analogue electrical signal-interchange device (56).

8. Method according to Claim 6 or 7, **characterised in that** for the purpose of changing the polarity of the analogue signal (20) the binary output signal (34) is inverted, in particular with the digital circuit (54, 66) or with the software of the microcontroller or microprocessor, and the change in the polarity of the analogue signal (20) is realised with the inverted output signal by the analogue electrical signal-interchange device (56) being driven accordingly.

9. Method according to one of the preceding claims, **characterised in that** the changed polarity of the analogue signal (20) is retained up until a further exceeding of the maximal steady-STATE time or up until the detection of an error in the data transmission, in particular an error in the bit-oriented and/or byte-oriented protocol, or up until the detection of a timing error or up until a break in communication.

10. Method according to one of Claims 2 to 9, **characterised in that** the change in the polarity of the analogue signal (20) has been coupled with a corresponding change of a logic level of the binary signal (34).

11. Method according to one of the preceding claims, **characterised in that** for the analogue threshold value (30) a value is predetermined that is less than a maximal offset of a component of hardware that is used for implementing the method, in particular a comparator element (26) with which the analogue signal (20) is compared with the threshold value (30).

12. Method according to one of the preceding claims, **characterised in that** any constant or slowly variable interfering components that are included are at least partly eliminated from the analogue signal (20) in particular with a suitable analogue electrical filter, in particular a high-pass filter (80), preferentially an RC element, before the analogue signal (20) is compared with the analogue threshold value (30) and before its polarity is changed.

13. Method according to one of Claims 1 to 11, **characterised in that** the analogue signal is compared with the sum of the threshold value and the smoothed analogue signal, in particular an analogue signal voltage (20) is transmitted to one of the two inputs of the signal-interchange device (56), and the analogue signal voltage (20) smoothed by a low-pass filter (90), in particular by an RC element, preferentially plus an analogue threshold-value voltage, is transmitted to the other input of the signal-interchange device (56).

14. Method according to one of Claims 1 to 11, **characterised in that** the threshold value is determined as the smoothed amplitude of the analogue signal and is compared with a fraction of the non-smoothed analogue signal, in particular a voltage fraction (98, 100) of the analogue signal voltage (20), is transmitted to one of the two inputs of the signal-interchange device (56), downstream of which the comparator (26) is connected, and the analogue signal voltage (20), smoothed in particular with a low-pass filter (90), is transmitted to the other input of the signal-interchange device (56).

15. Method according to one of the preceding claims, **characterised in that** the data, in particular the data bits, of the data transmission are coded by pulses having a mean pulse length of less than 25 % of a bit time.

16. Method according to one of the preceding claims, **characterised in that** the data, in particular the data bits, are pulse-coded in accordance with the quasi-standard having the designation 'IrDA'.

17. Method according to one of Claims 1 to 14, **characterised in that** the data, in particular data bytes, are coded in accordance with ZVEI standard IEC 1107.

18. Method according to one of the preceding claims, **characterised in that** the data are transmitted between at least one mobile appliance and one stationary appliance or between two mobile appliances.

19. Method according to one of the preceding claims, **characterised in that** the data are transmitted from and/or to a consumption meter, in particular a stationary consumption meter, in particular a heating-cost allocator or an electricity meter, a gas meter, a water meter or a calorimeter.

20. Method according to one of Claims 1 to 19, **characterised in that** the analogue signal (20) is generated by optoelectronic means.

21. Apparatus for transmitting data of at least one pulsiform analogue signal (20) which characterises data to be transmitted having predetermined limited STATE time, with a converter for converting the analogue signal into a digital signal, said converter exhibiting:
a) a means (26) for comparing the analogue signal (20) with a predetermined analogue threshold value (30) and for generating a binary output signal (34) when the amplitude of the analogue signal (20) is greater than the analogue threshold value (30);
b) a controllable analogue electrical signal-interchange device (56) with which the analogue signal (20) and the analogue threshold value (30) are interchangeable; and
c) a time-monitoring circuit (66, 74-78) which places the signal-interchange device into the respective other switching state when an interference is present;
**characterised**
d) **in that** the time-monitoring circuit (66, 74-78) controls the signal-interchange device (56) into the respective other switching state when the STATE time of the binary analogue signal (34) attains the maximal steady-STATE time.

22. Apparatus according to Claim 21, **characterised in that** the comparator means is an analogue electrical comparator (26), and at least one output of the signal-interchange device (56) has been connected upstream of at least one input of the comparator (26).

23. Apparatus according to Claim 21 or 22, **characterised in that** the data transmission has been organised using bit-oriented and/or byte-oriented protocols.

24. Apparatus according to Claim 23, **characterised in that** the limited steady-STATE time and the maximal steady-STATE time have been predetermined by the bit-oriented and/or byte-oriented protocol.

25. Apparatus according to one of Claims 21 to 24, **characterised in that** a retriggerable monoflop (74) and a flip-flop (76) for registering an exceeding of the maximal steady-STATE time have been connected downstream of the converter, in particular of the comparator means (26).

26. Apparatus according to one of Claims 21 to 25, **characterised in that** a digital circuit or a microcontroller or microprocessor with software for registering the exceeding of the maximal steady-STATE time and for changing the polarity of the analogue signal (20), in particular a time-monitoring circuit circuit (66) connected downstream of the comparator means (26) or integrated into the comparator means (26) and/or into the signal-interchange device (56), or a microcontroller or microprocessor has been provided.

27. Apparatus according to Claim 26, **characterised in that** the time-monitoring circuit (66) or the software of the microcontroller or microprocessor exhibits a means (54) for inverting the binary output signal (34), and the analogue electrical signal-interchange device (56) has been controllably connected to the time-monitoring circuit (66) or to the microcontroller or microprocessor for changing the polarity of the analogue signal (20).

28. Apparatus according to one of Claims 21 to 27, **characterised by** a storage means, in particular a microcontroller or microprocessor with software, or by a flip-flop (76) for holding the changed polarity of the analogue signal (20) up until a further exceeding of the maximal steady-STATE time or up until the detection of an error in the data transmission, in particular an error in the bit-oriented or byte-oriented protocol, or up until the detection of a timing error or up until a break in communication.

29. Apparatus according to one of Claims 21 to 28, **characterised in that** the change in the polarity of the analogue signal (20) has been coupled with a corresponding change of a logic level of the binary signal (34) at the output of the comparator means (26).

30. Apparatus according to one of Claims 21 to 29, **characterised in that** the analogue threshold value (30) is less than a maximal offset of the comparator means, in particular of the comparator (26), in particular the analogue signal (20) is applied at a first input (24) of the comparator means (26), and the analogue threshold value (30) is applied to a second input (28) of the comparator means (26).

31. Apparatus according to one of Claims 21 to 30, **characterised in that** a suitable analogue electrical filter, in particular a high-pass filter, preferentially an RC element (80), has been connected upstream of the comparator means (14) and/or of the analogue electrical signal-interchange device (56) for the purpose of at least partly eliminating from the analogue signal (20) any constant or slowly variable interfering components that are included.

32. Apparatus according to one of Claims 21 to 31, **characterised in that** a means for smoothing the analogue signal (20), in particular a low-pass filter (90), preferentially an RC element, and a means for adding the threshold value (30) and the smoothed analogue signal (20) applied at the output of the low-pass filter (90) have been connected upstream of the comparator means (26) and/or of the analogue electrical signal-interchange device (56), in particular the analogue signal (20) is applied simultaneously at one of the two inputs of the signal-interchange device (56) with the downstream comparator means (26) and at the input of the low-pass filter (90), the low-pass filter (90) and a means (30) for generating a threshold voltage characterising the analogue electrical threshold value having been connected in series with the other input of the signal-interchange device (56).

33. Apparatus according to one of Claims 21 to 30, **characterised in that** a means (96) for forming an amplitude fraction of the analogue signal (20), in particular a voltage divider (96), has been provided upstream of a first input (24) of the comparator means (26) and/or of the analogue electrical signal-interchange device (56), and a means for smoothing the analogue signal (20), in particular a low-pass filter (90), has been connected upstream of a second input (28) of the comparator means (26) and/or of the analogue electrical signal-interchange device (56).

34. Apparatus according to one of Claims 21 to 33, **characterised in that** the data, in particular the data bits, of the data transmission comprise pulses having a mean duration of less than 25 % of a bit time.

35. Apparatus according to one of Claims 21 to 34, **characterised in that** the data, in particular the data bits, have been pulse-coded in accordance with the quasi-standard having the designation 'IrDA'.

36. Apparatus according to one of Claims 21 to 35, **characterised in that** data, in particular data bytes, have been coded in accordance with ZVEI standard IEC 1107.

37. Apparatus according to one of Claims 21 to 36, **characterised in that** it has been functionally connected to a mobile appliance or to a stationary appliance or has been integrated therein.

38. Apparatus according to one of Claims 21 to 37, **characterised in that** it has been functionally connected, in particular, to a stationary consumption meter, in particular to a heating-cost allocator or to an electricity meter, a gas meter, a water meter or a calorimeter, or has been integrated therein.

39. Apparatus according to one of Claims 21 to 38, **characterised in that** the analogue signal (20) has been derived from the output voltage of a light-sensitive transducer (14) which is part of an optical coupler of an optical data-transmission link.

## Revendications

1. Procédé de transmission de données, dans lequel au moins un signal analogique sous forme d'impulsions (20), lequel caractérise des données numériques transmises avec un temps d'ÉTAT limité prédéfini, est converti en un signal numérique, dans lequel
a) le signal analogique (20) est comparé à une valeur seuil analogique (30) prédéfinie et un signal de sortie binaire (34) est généré aussi longtemps que la comparaison indique que l'amplitude du signal analogique (20) est supérieure à la valeur seuil (30),
b) le signal analogique (20) et la valeur seuil (30) peuvent être permutés pour réduire l'influence de signaux perturbateurs, en particulier de signaux de dérive,
**caractérisé en ce que**
c) la permutation du signal analogique (20) et de la valeur seuil (30) est effectuée lorsque le signal de sortie binaire (34) est généré plus longtemps qu'un temps d'ÉTAT permanent maximal prédéfini pour le signal de sortie binaire (34).

2. Procédé selon la revendication 1, **caractérisé en ce que** le signal analogique (20) est comparé à la valeur seuil analogique (30) avec un comparateur électrique analogique (26) et la permutation du signal analogique (20) et de la valeur seuil (30) est effectuée avec un dispositif de permutation de signaux commandable (56).

3. Procédé selon la revendication 1 ou 2, **caractérisé en ce que** la transmission de données est organisée avec des protocoles orientés bit et/ou octet.

4. Procédé selon la revendication 3, **caractérisé en ce que** le temps d'ÉTAT permanent maximal est prédéfini par le protocole orienté bit et/ou octet.

5. Procédé selon une des revendications 1 à 4, **caractérisé en ce qu'**un dépassement du temps d'ÉTAT permanent maximal est détecté avec une bascule monostable redéclenchable (74) et une bascule bistable (76) placée en aval.

6. Procédé selon une des revendications 1 à 4, **caractérisé en ce qu'**un dépassement du temps d'ÉTAT permanent maximal et un changement de polarité du signal analogique (20) sont réalisés par un circuit numérique (54, 66) ou un logiciel d'un microcontrôleur ou d'un microprocesseur.

7. Procédé selon la revendication 6, **caractérisé en ce que** le dépassement du temps d'ÉTAT permanent maximal et le changement de polarité du signal analogique (20) sont réalisés par un circuit de surveillance de temps (66) placé en aval du comparateur (26) ou intégré dans le comparateur (26) et/ou le dispositif de permutation de signaux électrique analogique (56).

8. Procédé selon la revendication 6 ou 7, **caractérisé en ce que** pour changer la polarité du signal analogique (20), le signal de sortie binaire (34) est inversé en particulier avec le circuit numérique (54, 66) ou le logiciel du microcontrôleur ou du microprocesseur et le changement de polarité du signal analogique (20) est réalisé avec le signal de sortie inversé en commandant en conséquence le dispositif de permutation de signaux électrique analogique (56).

9. Procédé selon une des revendications précédentes, **caractérisé en ce que** la polarité changée du signal analogique (20) est maintenue jusqu'à un nouveau dépassement du temps d'ÉTAT permanent maximal ou jusqu'à la détection d'une erreur dans la transmission de données, en particulier d'une erreur dans le protocole orienté bit et/ou octet, ou jusqu'à la détection d'une erreur de temporisation ou jusqu'à une pause de communication.

10. Procédé selon une des revendications 2 à 9, **caractérisé en ce que** le changement de polarité du signal analogique (20) est couplé à un changement correspondant d'un niveau logique du signal binaire (34).

11. Procédé selon une des revendications précédentes, **caractérisé en ce qu'**une valeur est prédéfinie pour la valeur seuil analogique (30), laquelle est inférieure à un décalage maximal d'un composant d'un matériel utilisé pour réaliser le procédé, en particulier d'un composant de comparaison (29) avec lequel le signal analogique (20) est comparé à la valeur seuil (30).

12. Procédé selon une des revendications précédentes, **caractérisé en ce que** des composantes perturbatrices constantes ou lentement variables éventuellement contenues sont éliminées au moins partiellement du signal analogique (20) en particulier avec un filtre électrique analogique approprié, en particulier un filtre passe-haut (80), de préférence un circuit RC, avant que le signal analogique (20) soit comparé à la valeur seuil analogique (30), respectivement avant que sa polarité soit changée.

13. Procédé selon une des revendications 1 à 11, **caractérisé en ce que** le signal analogique est comparé à la somme de la valeur seuil et du signal analogique lissé, en particulier une tension de signal analogique (20) est appliquée à une des deux entrées du dispositif de permutation de signaux (56) et la tension de signal analogique (20) lissée par un filtre passe-bas (90), en particulier un circuit RC, à l'autre entrée du dispositif de permutation de signaux (56), de préférence augmentée d'une tension de valeur seuil analogique.

14. Procédé selon une des revendications 1 à 11, **caractérisé en ce que** la valeur seuil est déterminée comme amplitude lissée du signal analogique et comparée à une fraction du signal analogique non lissé, en particulier une fraction de tension (98, 100) de la tension de signal analogique (20) est appliquée à une des deux entrées du dispositif de permutation de signaux (56) qui est placée en aval du comparateur (26), et la tension de signal analogique (20) lissée en particulier par un filtre passe-bas (90) est appliquée à l'autre entrée du dispositif de permutation de signaux (56).

15. Procédé selon une des revendications précédentes, **caractérisé en ce que** les données, en particulier les bits de données, de la transmission de données sont codées par des impulsions d'une longueur d'impulsion moyenne inférieure à 25 % d'un temps de bit.

16. Procédé selon une des revendications précédentes, **caractérisé en ce que** les données, en particulier les bits de données, sont codées par impulsions conformément à la quasi norme portant la désignation « IrDA ».

17. Procédé selon une des revendications 1 à 14, **caractérisé en ce que** les données, en particulier les bits de données, sont codées conformément à la norme ZVEI IEC 1107.

18. Procédé selon une des revendications précédentes, **caractérisé en ce que** les données sont transmises entre au moins un appareil mobile et un appareil fixe ou entre deux appareils mobiles.

19. Procédé selon une des revendications précédentes, **caractérisé en ce que** les données sont transmises de et/ou vers un compteur de consommation en particulier fixe, en particulier un répartiteur de coûts de chauffage ou un compteur d'électricité, de gaz, d'eau ou de chaleur.

20. Procédé selon une des revendications 1 à 19, **caractérisé en ce que** le signal analogique (20) est généré par voie optoélectronique.

21. Dispositif de transmission de données d'au moins un signal analogique sous forme d'impulsions (20), lequel caractérise des données à transmettre avec un temps d'ÉTAT limité prédéfini, comprenant un convertisseur pour convertir le signal analogique en un signal numérique, qui présente :
a) un moyen (26) pour comparer le signal analogique (20) à une valeur seuil analogique (30) prédéfinie et pour générer un signal de sortie binaire (34) lorsque l'amplitude du signal analogique (20) est supérieure à la valeur seuil analogique ;
b) un dispositif de permutation de signaux électrique analogique commandable (56) avec lequel le signal analogique (20) et la valeur seuil analogique (30) peuvent être permutés ; et
c) un circuit de surveillance de temps (66, 74-78) qui met le dispositif de permutation de signaux dans l'autre état de commutation respectif en cas de présence d'une perturbation ;
**caractérisé en ce**
d) **que** le circuit de surveillance de temps (66, 74-78) met le dispositif de permutation de signaux (56) dans l'autre état de commutation respectif lorsque le temps d'ÉTAT du signal de sortie binaire (34) atteint le temps d'ÉTAT permanent maximal.

22. Dispositif selon la revendication 21, **caractérisé en ce que** le moyen de comparaison est un comparateur électrique analogique (26) et au moins une sortie du dispositif de permutation de signaux (56) est placée en amont d'au moins une entrée du comparateur (26).

23. Dispositif selon la revendication 21 ou 22, **caractérisé en ce que** la transmission de données est organisée avec des protocoles orientés bit et/ou octet.

24. Dispositif selon la revendication 22, **caractérisé en ce que** le temps d'ÉTAT limité permanent et le temps d'ÉTAT permanent maximal sont prédéfinis par le protocole orienté bit et/ou octet.

25. Dispositif selon une des revendications 21 à 24, **caractérisé en ce qu'**une bascule monostable redéclenchable (74) et une bascule bistable (76) sont placées en aval du convertisseur, en particulier du moyen de comparaison (26), pour détecter un dépassement du temps d'ÉTAT permanent maximal.

26. Dispositif selon une des revendications 21 à 25, **caractérisé en ce qu'**un circuit numérique ou un microcontrôleur ou un microprocesseur avec un logiciel pour détecter le dépassement du temps d'ÉTAT permanent maximal et pour changer la polarité du signal analogique (20), en particulier un circuit de surveillance de temps (66) placé en aval du moyen de comparaison (26) ou intégré dans le moyen de comparaison (26) et/ou dans le dispositif de permutation de signaux (56) ou un microcontrôleur ou un microprocesseur est prévu.

27. Dispositif selon la revendication 26, **caractérisé en ce que** le circuit de surveillance de temps (66), respectivement le logiciel du microcontrôleur ou du microprocesseur, présente un moyen (54) pour inverser le signal de sortie numérique (34) et le dispositif de permutation de signaux électrique analogique (56) est relié de manière commandable au circuit de surveillance de temps (66), respectivement au microcontrôleur ou au microprocesseur, pour changer la polarité du signal analogique (20).

28. Dispositif selon une des revendications 21 à 27, **caractérisé par** un moyen de stockage, en particulier un microcontrôleur ou un microprocesseur avec un logiciel ou une bascule bistable (76) pour maintenir la polarité changée du signal analogique (20) jusqu'à un nouveau dépassement du temps d'ÉTAT permanent maximal ou jusqu'à la détection d'une erreur dans la transmission de données, en particulier d'une erreur dans le protocole orienté bit et/ou octet ou jusqu'à la détection d'une erreur de temporisation ou jusqu'à une pause de communication.

29. Dispositif selon une des revendications 21 à 28, **caractérisé en ce que** le changement de polarité du signal analogique (20) est couplé à un changement correspondant d'un niveau logique du signal binaire (34) à la sortie du moyen de comparaison (26).

30. Dispositif selon une des revendications 21 à 29, **caractérisé en ce que** la valeur seuil analogique (30) est inférieure à un décalage maximal du moyen de comparaison, en particulier du comparateur (26), en particulier le signal analogique (20) est appliqué à une première entrée (24) du moyen de comparaison (26) et la valeur seuil analogique (30) à une deuxième entrée (28) du moyen de comparaison (26).

31. Dispositif selon une des revendications 21 à 30, **caractérisé en ce qu'**un filtre électrique analogique approprié, en particulier un filtre passe-haut, de préférence un circuit RC (80), pour éliminer au moins partiellement du signal analogique (20) des composantes perturbatrices constantes ou lentement variables éventuellement contenues est placé en amont du moyen de comparaison (14) et/ou du dispositif de permutation de signaux électrique analogique (56).

32. Dispositif selon une des revendications 21 à 31, **caractérisé en ce qu'**un moyen pour lisser le signal analogique (20), en particulier un filtre passe-bas (90), de préférence un circuit RC, et un moyen pour additionner la valeur seuil (30) et le signal analogique lissé présent à la sortie du filtre passe-bas (90) sont placés en amont du moyen de comparaison (26) et/ou du dispositif de permutation de signaux électrique analogique (56), en particulier le signal analogique (20) est appliqué en même temps à une des deux entrées du dispositif de permutation de signaux (56) avec le moyen de comparaison (26) placé en aval et à l'entrée du filtre passe-bas (90), le filtre passe-bas (90) et un moyen (30) pour générer une tension de seuil caractéristique de la valeur seuil électrique analogique étant placés en série en amont de l'autre entrée du dispositif de permutation de signaux (56).

33. Dispositif selon une des revendications 21 à 30, **caractérisé en ce qu'**un moyen (96) pour former une fraction d'amplitude du signal analogique (20), en particulier un diviseur de tension (96), est placé en aval d'une première entrée (24) du moyen de comparaison (26) et/ou du dispositif de permutation de signaux électrique analogique (56) et un moyen pour lisser le signal analogique (20), en particulier un filtre passe-bas (90), en aval d'une deuxième entrée (28) du moyen de comparaison (26) et/ou du dispositif de permutation de signaux électrique analogique (56).

34. Dispositif selon une des revendications 21 à 33, **caractérisé en ce que** les données, en particulier les bits de données, de la transmission de données comprennent des impulsions d'une durée moyenne inférieure à 25 % d'un temps de bit.

35. Dispositif selon une des revendications 21 à 34, **caractérisé en ce que** les données, en particulier les bits de données, sont codées par impulsions conformément à la quasi norme portant la désignation « IrDA ».

36. Dispositif selon une des revendications 21 à 35, **caractérisé en ce que** les données, en particulier les bits de données, sont codées conformément à la norme ZVEI IEC 1107.

37. Dispositif selon une des revendications 21 à 36, **caractérisé en ce qu'**il est relié fonctionnellement à un appareil mobile ou à un appareil fixe ou intégré dans celui-ci.

38. Dispositif selon une des revendications 21 à 37, **caractérisé en ce qu'**il est en particulier relié fonctionnellement à un compteur de consommation fixe, en particulier à un répartiteur de coûts de chauffage ou à un compteur d'électricité, de gaz, d'eau ou de chaleur ou intégré dans ceux-ci.

39. Dispositif selon une des revendications 21 à 38, **caractérisé en ce que** le signal analogique (20) est dérivé de la tension de sortie d'un convertisseur photosensible (14) qui fait partie d'un optocoupleur d'une voie de transmission de données optique.
